# EUROPEAN PATENT APPLICATION

(11) **EP 4 503 895 A1**
(43) Date of publication of application: **05.02.2025**
(21) Application number: 24186749.8
(22) Date of filing: 05.07.2024
(51) Int. Cl.: H10K 59/122, H10K 59/124

(54) **DISPLAY DEVICE AND METHOD OF MANUFACTURING THE SAME**

(30) Priority: 31.07.2023 KR 20230099536
(71) Applicant: Samsung Display Co., Ltd., Gyeonggi-do 17113 (KR)
(72) Inventor: YOU, Chungi, 17113 Yongin-si (KR)
(74) Representative: Marks & Clerk LLP

(57) **Abstract**

A display device includes a base substrate including a display area including a first pixel area and a second pixel area, a transistor layer on the base substrate and including a first pixel circuit part corresponding to the first pixel area and a second pixel circuit part corresponding to the second pixel area, an insulating layer on the transistor layer having a first trench located between the first pixel area and the second pixel area, a first pixel electrode on the insulating layer and electrically connected to the first pixel circuit part, a second pixel electrode on the insulating layer and electrically connected to the second pixel circuit part, and a pixel defining layer on the insulating layer, the first pixel electrode, and the second pixel electrode extending into the first trench, and covering an inner surface of the first trench.

## Description

### BACKGROUND

### 1. Field

The present disclosure relates to a display device and a method of manufacturing the display device. More specifically, the present disclosure relates to a display device that provides visual information and a method of manufacturing the display device.

### 2. Description of the Related Art

As information technology develops, the importance of a display device as a connection medium between a user and information is being highlighted. For example, the use of display devices such as a liquid crystal display device (LCD), an organic light emitting display device (OLED), a plasma display device (PDP), and/or a quantum dot display device is increasing.

The display device includes red, green, and blue pixels, and each pixel includes a light emitting element that emits light. Additionally, in order to improve luminous efficiency of the light emitting element, the light emitting element includes at least one common layer (e.g., a hole transport layer, an electron transport layer, etc.).

### SUMMARY

One or more embodiments of the present disclosure provide a display device.

One or more embodiments of the present disclosure provide a method for manufacturing the display device.

A display device according to one or more embodiments includes a base substrate including a display area including a first pixel area and a second pixel area and a peripheral area around the display area, a transistor layer on the base substrate and including a first pixel circuit part corresponding to the first pixel area and a second pixel circuit part corresponding to the second pixel area, an insulating layer on the transistor layer and having contact holes exposing the first pixel circuit part and the second pixel circuit part and a first trench located between the first pixel area and the second pixel area, a first pixel electrode located at the first pixel area on the insulating layer and electrically connected to the first pixel circuit part, a second pixel electrode located at the second pixel area on the insulating layer and electrically connected to the second pixel circuit part, and a pixel defining layer on the insulating layer, the first pixel electrode, and the second pixel electrode, exposing a portion of each of the first pixel electrode and the second pixel electrode, extending into the first trench, and covering an inner surface of the first trench.

In one or more embodiments, the pixel defining layer may include a first defining layer on the insulating layer and spaced apart from the first trench in a plan view, a second defining layer on the first defining layer and spaced from the first trench in a plan view, and a third defining layer on the second defining layer, extending into the first trench, and covering the inner surface of the first trench.

In one or more embodiments, the insulating layer may include an organic material, and each of the first defining layer, the second defining layer, and the third defining layer may include at least one of silicon oxide, silicon nitride, or silicon carbonitride.

In one or more embodiments, in a cross-sectional view, a width of the first trench may be smaller than a separation distance between the first pixel electrode and the second pixel electrode, and a thickness of the third defining layer may be smaller than the width of the first trench.

In one or more embodiments, a side surface of the pixel defining layer may have a step-shaped step.

In one or more embodiments, the display device may further include a common layer on the insulating layer and the pixel defining layer and disconnected by the first trench and a common electrode on the common layer and not disconnected by the first trench.

In one or more embodiments, the common layer may include a first hole transport layer, a first light emitting layer on the first hole transport layer, a first electron transport layer on the first light emitting layer, a first charge generation layer on the first electron transport layer, a second hole transport layer on the first charge generation layer, a second light emitting layer on the second hole transport layer, a second electron transport layer on the second light emitting layer, a second charge generation layer on the second electron transport layer, a third hole transport layer on the second charge generation layer, a third light emitting layer on the third hole transport layer, and a third electron transport layer on the third light emitting layer.

In one or more embodiments, the display device may further include a first dam in the peripheral area and surrounding the display area and a second dam in the peripheral area and surrounding the first dam, and the first dam may include a first lower dam including a same material as the insulating layer and having a second trench surrounding the display area, a first upper dam on the first lower dam and spaced apart from the second trench in a plan view, a second upper dam on the first upper dam and spaced apart from the second trench in a plan view, and a third upper dam on the second upper dam, extending into the second trench, and covering an inner surface of the second trench.

In one or more embodiments, the first lower dam may include an organic material, and each of the first upper dam, the second upper dam, and the third upper dam may include at least one of silicon oxide, silicon nitride, or silicon carbonitride.

In one or more embodiments, the second dam may include a second lower dam including a same material as the insulating layer and having a third trench surrounding the display area, a fourth upper dam on the second lower dam and spaced from the third trench in a plan view, a fifth upper dam on the fourth upper dam and spaced from the third trench in a plan view, and a sixth upper dam on the fifth upper dam, extending into the third trench, and covering an inner surface of the third trench.

In one or more embodiments, the second lower dam may include an organic material, and each of the fourth upper dam, the fifth upper dam, and the sixth upper dam may include at least one of silicon oxide, silicon nitride, or silicon carbonitride.

In one or more embodiments, each of the second trench and the third trench may have a closed-loop shape.

In one or more embodiments, the base substrate may include a silicon wafer.

In one or more embodiments, the display device may further include a connection pattern in the contact holes of the insulating layer, and the connection pattern may electrically connect the first pixel electrode and the first pixel circuit part, and may electrically connect the second pixel electrode and the second pixel circuit part.

A method of manufacturing a display device according to one or more embodiments includes forming a transistor layer including a first pixel circuit part corresponding to a first pixel area and a second pixel circuit part corresponding to a second pixel area on a base substrate including a display area including the first pixel area and the second pixel area and a peripheral area around the display area, forming an insulating layer on the transistor layer, forming a first pixel electrode in the first pixel area and a second pixel electrode in the second pixel area on the insulating layer, forming a first preliminary defining layer on the insulating layer to cover the first pixel electrode and the second pixel electrode and exposing a portion of the insulating layer, forming a second preliminary defining layer exposing a portion of the insulating layer on the first preliminary defining layer, forming a first trench located between the first pixel area and the second pixel area by removing a portion of the insulating layer exposed from the first preliminary defining layer and the second preliminary defining layer, forming a third preliminary defining layer on the insulating layer and the second preliminary defining layer to extend into the first trench and cover an inner surface of the first trench, and forming a pixel defining layer exposing a portion of each of the first pixel electrode and the second pixel electrode, extending into the first trench, and covering the inner surface of the first trench by removing a portion of the first preliminary defining layer, a portion of the second preliminary defining layer, and a portion of the third preliminary defining layer.

In one or more embodiments, each of the first preliminary defining layer, the second preliminary defining layer, and the third preliminary defining layer may include at least one of silicon oxide, silicon nitride, or silicon carbonitride.

In one or more embodiments, in a cross-sectional view, a width of the first trench may be smaller than a separation distance between the first pixel electrode and the second pixel electrode, and a thickness of the third preliminary defining layer may be smaller than the width of the first trench.

In one or more embodiments, the pixel defining layer may include a first defining layer on the insulating layer formed by removing the portion of the first preliminary defining layer, a second defining layer on the first defining layer formed by removing the portion of the second preliminary defining layer, and a third defining layer on the second defining layer formed by removing the portion of the third preliminary defining layer, the first defining layer and the second defining layer may be spaced from the first trench, and the third defining layer may extend into the first trench and cover the inner surface of the first trench.

In one or more embodiments, the method may further include the pixel defining layer include forming a common layer disconnected by the first trench on the insulating layer and the pixel defining layer and forming a common electrode on the common layer that is not disconnected by the first trench, and the forming the common layer and the forming the common electrode may be performed after the forming the pixel defining layer.

In one or more embodiments, in the forming the insulating layer, a first lower dam in the peripheral area and surrounding the display area and a second lower dam in the peripheral area and surrounding the first lower dam may be formed, and in the forming the first trench, a second trench surrounding the display area is formed on the first lower dam, and a third trench surrounding the second trench may be formed on the second lower dam.

In one or more embodiments, the second trench and the third trench may be formed to have a closed-loop shape.

In one or more embodiments, in the forming the pixel defining layer, a first upper dam may be formed on the first lower dam to be spaced from the second trench by removing the portion of the first preliminary defining layer, a second upper dam may be formed on the first upper dam to be spaced from the second trench by removing the portion of the second preliminary defining layer, and a third upper dam may be formed on the second upper dam to extend into the second trench and cover an inner surface of the second trench by removing the portion of the third preliminary defining layer.

In one or more embodiments, the first lower dam may be formed of an organic material, and each of the first upper dam, the second upper dam, and the third upper dam may include at least one of silicon oxide, silicon nitride, or silicon carbonitride.

In one or more embodiments, in the forming the pixel defining layer, a fourth upper dam may be formed on the second lower dam to be spaced apart from the third trench by removing the portion of the first preliminary defining layer, a fifth upper dam may be formed on the fourth upper dam to be spaced from the third trench by removing the portion of the second preliminary defining layer, and a sixth upper dam may be formed on the fifth upper dam to extend into the third trench and cover an inner surface of the third trench by removing the portion of the third preliminary defining layer.

In one or more embodiments, the second lower dam may include an organic material, and each of the fourth upper dam, the fifth upper dam, and the sixth upper dam may include at least one of silicon oxide, silicon nitride, or silicon carbonitride.

The display device according to embodiments may be divided into a display area and a peripheral area, and the display area may include a first pixel area and a second pixel area. In addition, the display device may include a transistor layer including a first pixel circuit part corresponding to the first pixel area and a second pixel circuit part corresponding to the second pixel area and an insulating layer on the transistor layer. Additionally, the insulating layer may define a trench located between the first pixel area and the second pixel area. Additionally, a pixel defining layer on the insulating layer may have a structure in which a plurality of layers are stacked, and the uppermost layer among the plurality of layers of the pixel defining layer may extend into the trench and may cover an inner surface of the trench.

At least some of the above and other features of the invention are set out in the claims.

Accordingly, by adjusting a width of the trench and a thickness of the uppermost layer of the pixel defining layer, a size of a residual space in the trench may be changed in various ways. Accordingly, a size of the residual space in the trench required to disconnect a common layer on the insulating layer and the pixel defining layer and avoid disconnecting a common electrode on the common layer may be easily implemented. In other words, the common layer may be disconnected by the trench, and the common electrode may not be disconnected by the trench.

Accordingly, as the common layer is disconnected by the trench, current applied from a first pixel electrode in the first pixel area to the common layer may not leak into the common layer on a second pixel electrode in the second pixel area. That is, current leakage between adjacent pixel areas by the common layer may be reduced or prevented. At the same time, the common electrode may not be disconnected by the trench. For example, the common electrode may be integrally without disconnection on an entire surface of the display area. Accordingly, a voltage drop (IR drop) phenomenon of the common electrode may be reduced or prevented.

Additionally, the display device may include a dam in the peripheral area, and the dam may define a trench formed together with the trench of the insulating layer. As the dam defines the trench, a phenomenon in which organic materials of the organic encapsulation layer of the thin film encapsulation layer sealing the display area flows outward from the dam may be further reduced or prevented.

It is to be understood that both the foregoing general description and the following detailed description are explanatory and are intended to provide further explanation of the invention as claimed.

### BRIEF DESCRIPTION OF THE DRAWINGS

Illustrative, non-limiting embodiments will be more clearly understood from the following detailed description taken in conjunction with the accompanying drawings.
FIG. 1 is a plan view illustrating a display device according to one or more embodiments.
FIG. 2 is a cross-sectional view illustrating the display device of FIG. 1.
FIG. 3 is a cross-sectional view illustrating a thin film encapsulation layer, a color conversion layer, and a glass encapsulation layer included in the display device of FIG. 2.
FIG. 4 is a plan view illustrating a stacked structure of a base substrate, a transistor layer, and a light emitting element layer included in the display device of FIG. 2.
FIG. 5 is a cross-sectional view illustrating a stacked structure of a first pixel area included in the light emitting element layer of FIG. 4.
FIG. 6 is a cross-sectional view taken along the line I-I' of FIG. 4 according to one or more embodiments.
FIG. 7 is a cross-sectional view taken along the line II-II' of FIG. 1 according to one or more embodiments.
FIGS. 8 to 27 are views illustrating a method of manufacturing the display device of FIGS. 6 and 7.
FIG. 28 is a cross-sectional view taken along the line I-I' of FIG. 4 according to one or more embodiments.
FIG. 29 is a cross-sectional view taken along the line II-II' of FIG. 1 according to one or more embodiments.

### DETAILED DESCRIPTION

The present disclosure now will be described more fully hereinafter with reference to the accompanying drawings, in which various embodiments are shown. The present disclosure may, however, be embodied in many different forms, and should not be construed as limited to the embodiments set forth herein. Rather, these embodiments are provided so that the present disclosure will be thorough and complete, and will fully convey the scope of the present disclosure to those skilled in the art. Like reference numerals refer to like elements throughout.

For the purposes of the present disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression such as "at least one of A and B" may include A, B, or A and B. As used herein, the term "and/or" includes any and all combinations of one or more of the associated listed items. For example, the expression such as "A and/or B" may include A, B, or A and B. Further, the use of "may" when describing embodiments of the present disclosure refers to "one or more embodiments of the present disclosure".

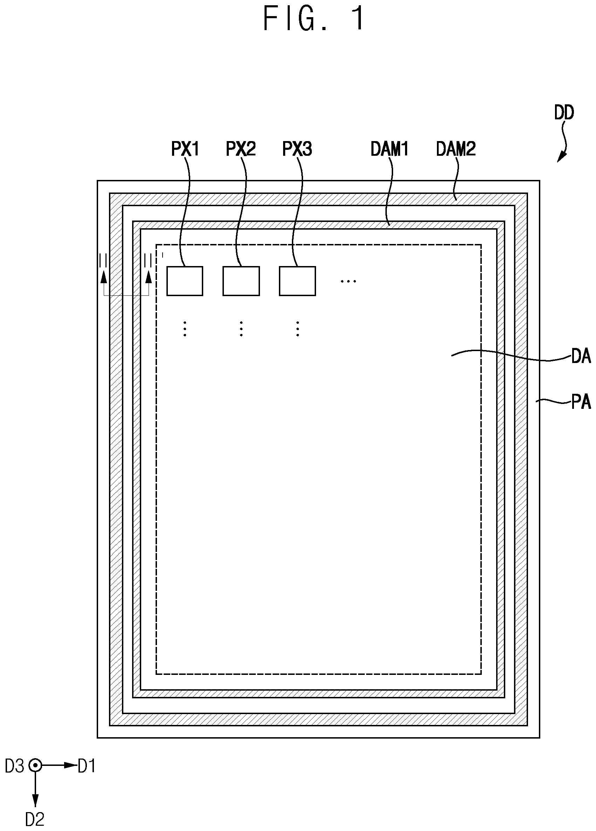

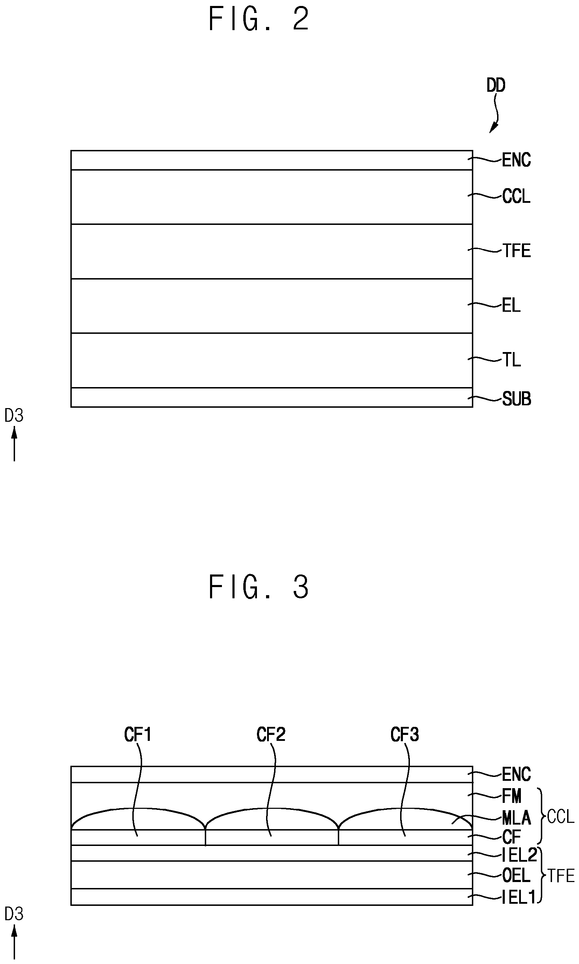

FIG. 1 is a plan view illustrating a display device according to one or more embodiments, and FIG. 2 is a cross-sectional view illustrating the display device of FIG. 1.

Referring to FIG. 1, the display device DD (e.g., a base substrate SUB in FIG. 2) according to one or more embodiments may include a display area DA and a peripheral area PA. The display area DA may be an area that can display an image by generating light or adjusting transmittance of light provided from an external light source. The peripheral area PA may be an area that does not display images. The peripheral area PA may be located around the display area DA. For example, the peripheral area PA may be around (e.g., may entirely surround) the display area DA.

The display area DA may include a plurality of pixel areas. The pixel areas may be arranged in a matrix form along a first direction D1 and a second direction D2 intersecting the first direction D1. For example, the pixel areas may be arranged along rows and columns of a matrix along the first direction D1 and the second direction D2. For example, the pixel areas may include a first pixel area PX1, a second pixel area PX2, and a third pixel area PX3.

Each of the first pixel area PX1, the second pixel area PX2, and the third pixel area PX3 may be an area where light emitted from a light emitting element is emitted to the outside of the display device DD. For example, the first pixel area PX1 may emit a first color light, the second pixel area PX2 may emit a second color light, and the third pixel area PX3 may emit a third color light. In one or more embodiments, the first light may be red light, the second light may be green light, and the third light may be blue light. However, the present disclosure is not limited thereto. For example, the first to third pixel areas PX1, PX2, and PX3 may be combined to emit yellow, cyan, and magenta lights.

Each of the first pixel area PX1, the second pixel area PX2, and the third pixel area PX3 may have a triangular planar shape, a square planar shape, a circular planar shape, an oval planar shape, or the like. In one or more embodiments, each of the first pixel area PX1, the second pixel area PX2, and the third pixel area PX3 may have a rectangular planar shape. However, the present disclosure is not limited thereto, and each of the first pixel area PX1, the second pixel area PX2, and the third pixel area PX3 may have a planar shape other than a rectangle.

In addition, FIG. 1 illustrates that the first pixel area PX1, the second pixel area PX2, and the third pixel area PX3 have the same size, but the present disclosure is not necessarily limited thereto. The first pixel area PX1, the second pixel area PX2, and the third pixel area PX3 may have different sizes.

A first dam DAM1 and a second dam DAM2 may be located in the peripheral area PA. The first dam DAM1 may be around (e.g., may surround) the display area DA. The second dam DAM2 may be spaced from the first dam DAM1 and may be around (e.g., may surround) the first dam DAM1. In one or more embodiments, the first dam DAM1 and the second dam DAM2 may reduce or block a flow of organic material of an organic encapsulation layer of a thin film encapsulation layer sealing the display area DA outward from each of the first dam DAM1 and the second dam DAM2.

In the present disclosure, a plane may be defined as extending in the first direction D1 and the second direction D2. For example, the first direction D1 may be perpendicular to the second direction DR2. A third direction D3 may be a normal direction of the plane.

Referring to FIG. 2, the display device DD may include a base substrate SUB, a transistor layer TL, a light emitting element layer EL, a thin film encapsulation layer TFE, a color conversion layer CCL, and a glass encapsulation layer ENC. The transistor layer TL, the light emitting element layer EL, the thin film encapsulation layer TFE, the color conversion layer CCL, and the glass encapsulation layer ENC may be sequentially stacked on the base substrate SUB.

The base substrate SUB may include a silicon wafer. The base substrate SUB may be a support member for supporting other components of the display device DD.

The transistor layer TL may generate driving current. For example, the transistor layer TL may include pixel circuit parts. Each of the pixel circuit parts may include various driving elements, wiring, etc. for driving the light emitting element.

The light emitting element layer EL may emit light corresponding to the driving current. The thin film encapsulation layer TFE may prevent moisture and external air from penetrating into the light emitting element layer EL. The color conversion layer CCL may convert a color of light emitted from the light emitting element layer EL, and the glass encapsulation layer ENC may protect the light emitting element layer EL and color conversion layer CCL from impact.

FIG. 3 is a cross-sectional view illustrating a thin film encapsulation layer, a color conversion layer, and a glass encapsulation layer included in the display device of FIG. 2.

Referring to FIG. 3, the thin film encapsulation layer TFE may include a first inorganic encapsulation layer IEL1, an organic encapsulation layer OEL, and a second inorganic encapsulation layer IEL2. The color conversion layer CCL may include a color filter layer CF, a micro lens array MLA, and a filler FM.

The first inorganic encapsulation layer IEL1 may be disposed on the light emitting element layer EL. In one or more embodiments, the first inorganic encapsulation layer IEL1 may be formed of an inorganic material. Examples of the inorganic material that can be used as the first inorganic encapsulation layer IEL1 may include silicon oxide, silicon nitride, and/or silicon oxynitride. These can be used alone or in combination with each other.

The organic encapsulation layer OEL may be disposed on the first inorganic encapsulation layer IEL1. In one or more embodiments, the organic encapsulation layer OEL may be formed of an organic material. Examples of the organic material that can be used as the organic encapsulation layer OEL may include photoresist, polyacrylic resin, polyimide resin, and/or acrylic resin. These can be used alone or in combination with each other.

The second inorganic encapsulation layer IEL2 may be disposed on the organic encapsulation layer OEL and may be formed of substantially the same material as the first inorganic encapsulation layer IEL1.

The color filter layer CF may include a first color filter CF1, a second color filter CF2, and a third color filter CF3. In one or more embodiments, the first color filter CF1 may convert a color of light emitted from the light emitting element layer EL to red, and the second color filter CF2 may convert a color of light emitted from the light emitting element layer EL to green, and the third color filter CF3 may convert a color of light emitted from the light emitting element layer EL to blue. In other words, the first color filter CF1 may correspond to the first pixel area PX1, the second color filter CF2 may correspond to the second pixel area PX2, and the third color filter CF3 may correspond to the third pixel area PX3.

The micro lens array MLA may include a plurality of micro lenses. The micro lens array MLA may create a virtual image from the images provided by the light emitting element layer EL and the color filter layer CF, and may project the virtual image to the user's eyes.

The filler FM may protect the color filter layer CF and the micro lens array MLA from impact and may include a liquid polymer.

The glass encapsulation layer ENC may be formed of glass and may protect underlying components from impact.

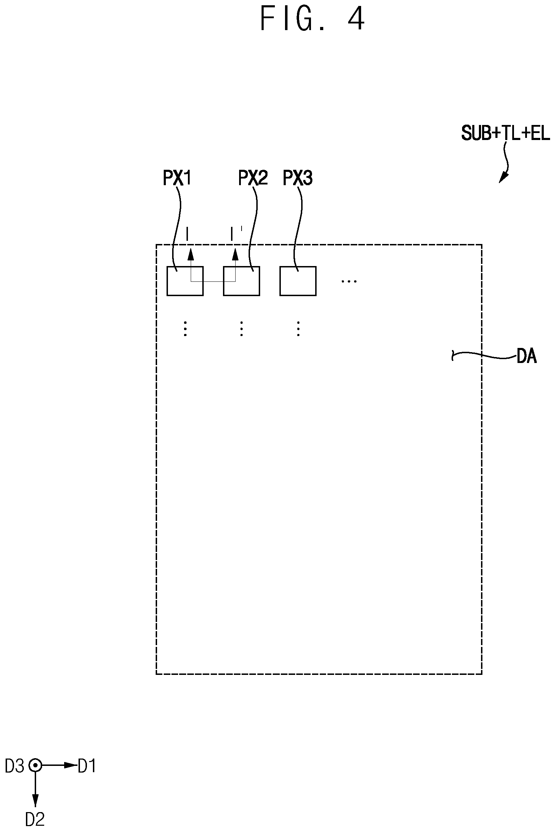

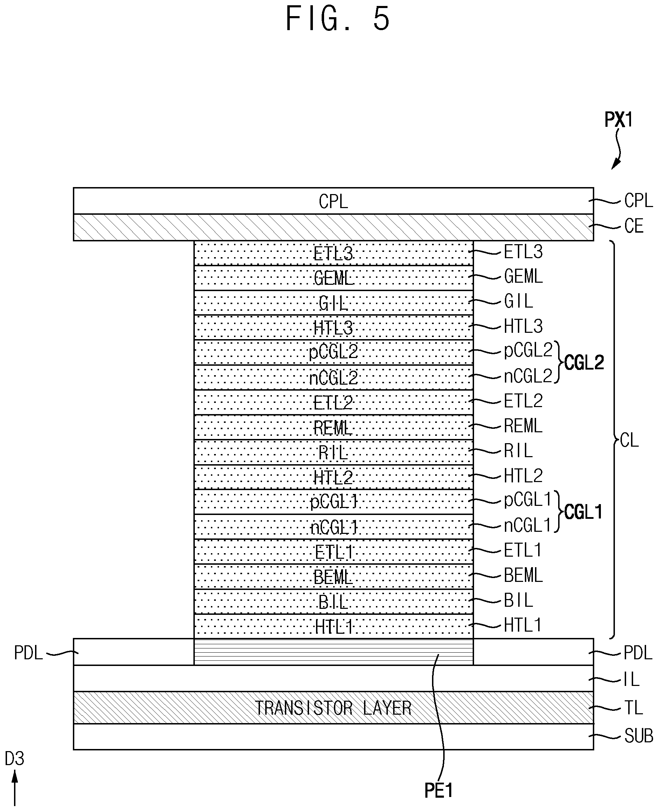

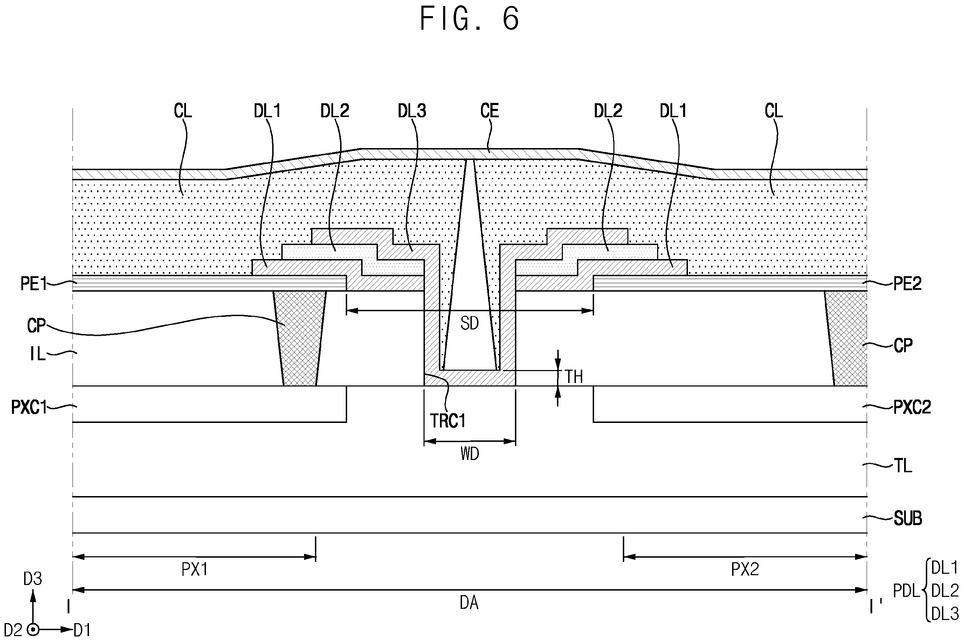

FIG. 4 is a plan view illustrating a stacked structure of a base substrate, a transistor layer, and a light emitting element layer included in the display device of FIG. 2, FIG. 5 is a cross-sectional view illustrating a stacked structure of a first pixel area included in the light emitting element layer of FIG. 4, and FIG. 6 is a cross-sectional view taken along the line I-I' of FIG. 4 according to one or more embodiments.

In one or more embodiments, a stacked structure of each of the second pixel area PX2 and the third pixel area PX3 may be substantially the same as the stacked structure of the first pixel area PX1 illustrated in FIG. 5. Therefore, a corresponding description is omitted.

Additionally, a cross-sectional structure between the second pixel area PX2 and the third pixel area PX3 may be substantially the same as the cross-sectional structure between the first pixel area PX1 and the second pixel area PX2 illustrated in FIG. 6. Therefore, a corresponding description is omitted.

Referring to FIGS. 4 and 5, a first pixel electrode PE1, a common layer CL, a common electrode CE, and a capping layer CPL may be disposed in the first pixel area PX1.

The common layer CL may be formed in all of the first to third pixel areas PX1, PX2, and PX3. The common layer CL may include a first hole transport layer HTL1, a first auxiliary layer BIL, a first light emitting layer BEML, a first electron transport layer ETL1, a first charge generation layer CGL1, a second hole transport layer HTL2, a second auxiliary layer RIL, a second light emitting layer REML, a second electron transport layer ETL2, a second charge generation layer CGL2, a third hole transport layer HTL3, a third auxiliary layer GIL, a third light emitting layer GEML, and a third electron transport layer ETL3. The first charge generation layer CGL1 may include a first n-type charge generation layer nCGL1 and a first p-type charge generation layer pCGL1, and the second charge generation layer CGL2 may include a second n-type charge generation layer nCGL2 and a second p-type charge generation layer pCGL2.

The first pixel electrode PE1 may be disposed on the transistor layer TL. In one or more embodiments, the first pixel electrode PE1 may be electrically connected to the transistor layer TL. For example, the first pixel electrode PE1 may be electrically connected to a first pixel circuit part PXC1 (in FIG. 6) corresponding to the first pixel area PX1 from among the pixel circuit parts of the transistor layer TL. The first pixel electrode PE1 may be formed of metal, alloy, metal oxide, reflective conductive material, and/or the like. Examples of materials that can be used as the first pixel electrode PE1 may include silver (Ag), an alloy containing silver, molybdenum (Mo), an alloy containing molybdenum, aluminium (Al), an alloy containing aluminium, aluminium nitride (AlN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), and/or the like. These can be used alone or in combination with each other.

The first hole transport layer HTL1 may be disposed on the first pixel electrode PE1. The first hole transport layer HTL1 may increase a mobility of holes. In one or more embodiments, the first hole transport layer HTL1 may include a hole transport material. Examples of materials that can be used as the first hole transport layer HTL1 may include HATCN (1,4,5,8,9,11-hexaazatriphenylene-hexanitrile), CuPc (cupper phthalocyanine), PEDOT (poly(3,4)-ethylenedioxythiophene), PANI (polyaniline), NPD (N,N-dinaphthyl-N,N'-diphenylbenzidine), or the like. These can be used alone or in combination with each other.

The first auxiliary layer BIL may be disposed on the first hole transport layer HTL1. The first auxiliary layer BIL may reinforce resonance of light emitted from the first light emitting layer BEML. In one or more embodiments, the first auxiliary layer BIL may be formed of an amine-based organic compound, and the resonance may be strengthened by adjusting a thickness of the first auxiliary layer BIL. In one or more embodiments, the first auxiliary layer BIL may include a highly reflective metal such as Ag and/or MgAg and a material for optical path adjustment such as SiN, SiO₂, TiO₂, Ta₂O₅, ITO, and/or IZO.

The first light emitting layer BEML may be disposed on the first auxiliary layer BIL. When electrons and holes are injected into the first light emitting layer BEML, the first light emitting layer BEML may emit light of a preset color. For example, the first light emitting layer BEML may be formed of an organic material that emits blue light, and may emit blue light. However, the present disclosure is not necessarily limited thereto.

The first electron transport layer ETL1 may be disposed on the first light emitting layer BEML. The first electron transport layer ETL1 may increase electron mobility. In one or more embodiments, the first electron transport layer ETL1 may include an electron transport material. Examples of materials that can be used as the first electron transport layer ETL1 may include 8-Hydroxyquinolinolato-lithium (LiQ), Alq3 (tris(8-hydroxyquinolino)aluminium), butyl-PBD (2-(4-biphenylyl)-5-(4-tert-butylpheny)-1,3,4oxadiazole), TAZ (3-(Biphenyl-4-yl)-5-(4-tert-butylphenyl)-4-phenyl-4H-1,2,4-triazole), spiro-PBD, and/or the like. These can be used alone or in combination with each other.

The first n-type charge generation layer nCGL1 may be disposed on the first electron transport layer ETL1. The first n-type charge generation layer nCGL1 may supply electrons to the first light emitting layer BEML. Examples of materials that can be used as the first n-type charge generation layer nCGL1 may include metals, alloys, metal oxides, reflective conductive materials, and/or organic materials doped with n-type materials.

The first p-type charge generation layer pCGL1 may be disposed on the first n-type charge generation layer nCGL1. The first p-type charge generation layer pCGL1 may supply holes to the second light emitting layer REML. Examples of materials that can be used as the first p-type charge generation layer pCGL1 may include metals, alloys, metal oxides, reflective conductive materials, and/or organic materials doped with p-type materials.

The second hole transport layer HTL2 may be disposed on the first p-type charge generation layer pCGL1. The second hole transport layer HTL2 may increase a mobility of holes. In one or more embodiments, the second hole transport layer HTL2 may include a hole transport material.

The second auxiliary layer RIL may be disposed on the second hole transport layer HTL2. The second auxiliary layer RIL may reinforce resonance of light emitted from the second light emitting layer REML.

The second light emitting layer REML may be disposed on the second auxiliary layer RIL. When electrons and holes are injected into the second light emitting layer REML, the second light emitting layer REML may emit light of a preset color. For example, the second light emitting layer REML may be formed of an organic material that emits red light, and may emit red light. However, the present disclosure is not necessarily limited thereto.

The second electron transport layer ETL2 may be disposed on the second light emitting layer REML. The second electron transport layer ETL2 may increase electron mobility. In one or more embodiments, the first electron transport layer ETL1 may include an electron transport material.

The second n-type charge generation layer nCGL2 may be disposed on the second electron transport layer ETL2. The second n-type charge generation layer nCGL2 may supply electrons to the second light emitting layer REML. Examples of materials that can be used as the second n-type charge generation layer nCGL2 may include metals, alloys, metal oxides, reflective conductive materials, and/or organic materials doped with n-type materials.

The second p-type charge generation layer pCGL2 may be disposed on the second n-type charge generation layer nCGL2. The second p-type charge generation layer pCGL2 may supply holes to the third light emitting layer GEML. Examples of materials that can be used as the second p-type charge generation layer pCGL2 may include metals, alloys, metal oxides, reflective conductive materials, and/or organic materials doped with p-type materials.

The third hole transport layer HTL3 may be disposed on the second p-type charge generation layer pCGL2. The third hole transport layer HTL3 may increase a mobility of holes. In one or more embodiments, the third hole transport layer HTL3 may include a hole transport material.

The third auxiliary layer GIL may be disposed on the third hole transport layer HTL3. The third auxiliary layer GIL may reinforce resonance of light emitted from the third light emitting layer GEML.

The third light emitting layer GEML may be disposed on the third auxiliary layer GIL. When electrons and holes are injected into the third light emitting layer GEML, the third light emitting layer GEML may emit light of a preset color. For example, the third light emitting layer GEML may be formed of an organic material that emits green light, and may emit green light. However, the present disclosure is not necessarily limited thereto.

The third electron transport layer ETL3 may be disposed on the third light emitting layer GEML. The third electron transport layer ETL3 may increase electron mobility. In one or more embodiments, the third electron transport layer ETL3 may include an electron transport material.

In one or more embodiments, a structure of the common layer CL illustrated in FIG. 5 is an example and may be changed in various ways depending on embodiments. For example, the common layer CL may have a structure in which at least one of the components illustrated in FIG. 5 is omitted or a structure that further includes components not illustrated in FIG. 5.

The common electrode CE may be disposed on the third electron transport layer ETL3. In one or more embodiments, the common electrode CE may include metal, alloy, metal oxide, reflective conductive material, and/or the like. Examples of materials that can be used as the common electrode CE may include silver (Ag), an alloy containing silver, molybdenum (Mo), an alloy containing molybdenum, aluminium (Al), an alloy containing aluminium, aluminium nitride (AlN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), and/or the like. These can be used alone or in combination with each other.

The capping layer CPL may be disposed on the common electrode CE. Using a refractive index of the capping layer CPL, the light emitted from the first light emitting layer BEML, the second light emitting layer REML, and the third light emitting layer GEML may be resonated, and light extraction efficiency of the first light emitting layer BEML, the second light emitting layer REML, and the third light emitting layer GEML may be improved. For example, the capping layer CPL may include an organic material and/or an inorganic material.

Referring further to FIG. 6, the transistor layer TL includes a first pixel circuit part PXC1 and a second pixel circuit part PXC2. The first pixel circuit part PXC1 corresponds to the first pixel area PX1, and the second pixel circuit part PXC2 corresponds to the second pixel area PX2. As described above, the first pixel circuit part PXC1 and the second pixel circuit part PXC2 may include various driving elements, wiring, etc. for driving the light emitting element.

An insulating layer IL is disposed on the transistor layer TL. The insulating layer IL may be disposed in the display area DA. The insulating layer IL may prevent contact between the pixel electrodes and the pixel circuit parts. The insulating layer IL may include an organic material. Examples of the organic material that can be used as the insulating layer IL may include photoresist, polyacrylic resin, polyimide resin, and/or acrylic resin. These can be used alone or in combination with each other.

The insulating layer IL includes contact holes that penetrate the insulating layer IL and expose the first pixel circuit part PXC1 and the second pixel circuit part PXC2. Each of the contact holes may be filled with a connection pattern CP. The connection pattern CP may be electrically connected to the first pixel circuit part PXC1 and the second pixel circuit part PXC2. For example, the connection pattern CP located in the first pixel area PX1 may be electrically connected to the first pixel circuit part PXC1, and the connection pattern CP located in the second pixel area PX2 may be electrically connected to the second pixel circuit part PXC2. In one or more embodiments, the connection pattern CP may include a conductive material. For example, the connection pattern CP may include tungsten (W).

The insulating layer IL has a first trench TRC1 located between the first pixel area PX1 and the second pixel area PX2. FIG. 6 illustrates that the first trench TRC1 exposes an upper surface of the transistor layer TL, but the present disclosure is not necessarily limited thereto. In one or more embodiments, the first trench TRC1 may not expose the upper surface of the transistor layer TL, but may extend only from an upper surface of the insulating layer IL to inside of the insulating layer IL. In one or more embodiments, the first trench TRC1 may extend from the upper surface of the insulating layer IL through the upper surface of the transistor layer TL to inside of the transistor layer TL.

Pixel electrodes may be disposed on the insulating layer IL. For example, the first pixel electrode PE1 may be disposed on the insulating layer IL to correspond to the first pixel area PX1, and the second pixel electrode PE2 may be disposed on the insulating layer IL to correspond to the second pixel area PX2. The first pixel electrode PE1 may be electrically connected to the first pixel circuit part PXC1 through the connection pattern CP, and the second pixel electrode PE2 may be electrically connected to the second pixel circuit part PXC2 through the connection pattern CP.

The first pixel electrode PE1 and the second pixel electrode PE2 may be spaced from the first trench TRC1. That is, the first pixel electrode PE1 and the second pixel electrode PE2 may be disposed with the first trench TRC1 therebetween. In other words, the first trench TRC1 may be located between the first pixel electrode PE1 and the second pixel electrode PE2. For example, a width WD of the first trench TRC1 may be smaller than a separation distance SD between the first pixel electrode PE1 and the second pixel electrode PE2.

A pixel defining layer PDL is disposed on the insulating layer IL, the first pixel electrode PE1, and the second pixel electrode PE2.

The pixel defining layer PDL may cover a portion of each of the first pixel electrode PE1 and the second pixel electrode PE2. That is, the pixel defining layer PDL may expose a portion of each of the first pixel electrode PE1 and the second pixel electrode PE2. For example, the pixel defining layer PDL may cover a side portion of each of the first pixel electrode PE1 and the second pixel electrode PE2, and expose a central portion of each of the first pixel electrode PE1 and the second pixel electrode PE2.

The pixel defining layer PDL extends into the first trench TRC1 and covers an inner surface of the first trench TRC1. For example, as illustrated in FIG. 6, the pixel defining layer PDL may extend into the first trench TRC1 and cover all surfaces defining the first trench TRC1.

In one or more embodiments, the pixel defining layer PDL may include a first defining layer DL1, a second defining layer DL2, and a third defining layer DL3. The first defining layer DL1, the second defining layer DL2, and the third defining layer DL3 may be sequentially stacked on the insulating layer IL.

The first defining layer DL1 may be disposed on the insulating layer IL and on a portion of each of the first pixel electrode PE1 and the second pixel electrode PE2, and spaced from the first trench TRC1 in a plan view. That is, the first defining layer DL1 may not be disposed inside the first trench TRC1. In one or more embodiments, the first defining layer DL1 may include an inorganic material. For example, the first defining layer DL1 may include silicon oxide, silicon nitride, and/or silicon carbonitride.

The second defining layer DL2 may be disposed on the first defining layer DL1 and may be spaced from the first trench TRC1 in a plan view. That is, the second defining layer DL2 may not be disposed inside the first trench TRC1. In one or more embodiments, the second defining layer DL2 may include an inorganic material. For example, the second defining layer DL2 may include silicon oxide, silicon nitride, and/or silicon carbonitride.

In one or more embodiments, the second defining layer DL2 may expose a portion of the first defining layer DL1. That is, an end of the first defining layer DL1 and an end of the second defining layer DL2 may define a step-shaped step (e.g. may define a step).

The third defining layer DL3 may be disposed on the second defining layer DL2, extend into the first trench TRC1, and cover the inner surface of the first trench TRC1. For example, as illustrated in FIG. 6, the third defining layer DL3 may extend into the first trench TRC1 and cover all surfaces defining the first trench TRC1. In other words, as the third defining layer DL3 extends into the first trench TRC1 and covers the inner surface of the first trench TRC1, the pixel defining layer PDL may extend into the first trench TRC1 and cover the inner surface of the first trench TRC1.

In one or more embodiments, the third defining layer DL3 may expose a portion of the second defining layer DL2. That is, the end of the second defining layer DL2 and an end of the third defining layer DL3 may define a step-shaped step. Accordingly, a side surface of the pixel defining layer PDL may have a step-shaped step. Accordingly, a step coverage of the common layer CL and the common electrode CE formed on the pixel defining layer PDL may be improved. Accordingly, durability of the display device DD may be improved.

A thickness TH of the third defining layer DL3 may be smaller than the width WD of the first trench TRC1. That is, even when the third defining layer DL3 covers the inner surface of the first trench TRC1, residual space may still remain in the first trench TRC1.

In one or more embodiments, as illustrated in FIG. 6, the pixel defining layer PDL may have a structure in which the first defining layer DL1, the second defining layer DL2, and the third defining layer DL3 are sequentially stacked. For example, the pixel defining layer PDL may have a three-layer structure in which the first defining layer DL1 including silicon nitride, the second defining layer DL2 including silicon oxide, and the third defining layer DL3 including silicon nitride are sequentially stacked. In addition, the pixel defining layer PDL may have a three-layer structure in which the first defining layer DL1 including silicon carbonitride, the second defining layer DL2 including silicon oxide, and the third defining layer DL3 including silicon carbonitride are sequentially stacked. In addition, the pixel defining layer PDL may have a three-layer structure in which the first defining layer DL1 including silicon oxide, the second defining layer DL2 including silicon nitride, and the third defining layer DL3 including silicon oxide are sequentially stacked. In addition, the pixel defining layer PDL may have a three-layer structure in which the first defining layer DL1 including silicon oxide, the second defining layer DL2 including silicon carbonitride, and the third defining layer DL3 including silicon oxide are sequentially stacked. However, this is only an example, and a stacked structure of the pixel defining layer PDL and materials of each layer constituting the pixel defining layer PDL may be variously changed according to one or more embodiments.

The common layer CL may be disposed on the insulating layer IL, the first pixel electrode PE1, the second pixel electrode PE2, and the pixel defining layer PDL, and may be disconnected by the first trench TRC1. Accordingly, the common layer CL disposed on the first pixel electrode PE1 and the common layer CL disposed on the second pixel electrode PE2 may not be electrically connected to each other.

For example, by adjusting the width WD of the first trench TRC1 and the thickness TD of the third defining layer DL3, a size of the residual space in the first trench TRC1 required to disconnect the common layer CL may be implemented. Accordingly, the common layer CL may be disconnected by the first trench TRC1.

Accordingly, current applied from the first pixel electrode PE1 corresponding to the first pixel area PX1 to the common layer CL may not leak into the common layer CL disposed on the second pixel electrode PE2. That is, current leakage between adjacent pixel areas by the common layer CL may be reduced or prevented.

The common electrode CE may be disposed on the common layer CL and may not be disconnected by the first trench TRC1. For example, the common electrode CE may be disposed integrally without disconnection on an entire surface of the display area DA.

For example, by adjusting the width WD of the first trench TRC1 and the thickness TD of the third defining layer DL3, a size of the residual space in the first trench TRC1 required to avoid disconnecting the common electrode CE may be easily implemented. Accordingly, the common electrode CE may not be disconnected by the first trench TRC1. Accordingly, a voltage drop (IR drop) phenomenon of the common electrode CE may be prevented.

As a result, according to one or more embodiments, the insulating layer IL disposed on the transistor layer TL may define the first trench TRC1 located between the first pixel area PX1 and the second pixel area PX2. Additionally, the pixel defining layer PDL on the insulating layer IL may have a structure in which a plurality of layers are stacked, and the uppermost layer (for example, the third defining layer DL3) from among the plurality of layers of the pixel defining layer PDL may extend into the first trench TRC1 and may cover the inner surface of the first trench TRC1.

Accordingly, by adjusting the width of the first trench TRC1 and the thickness of the uppermost layer of the pixel defining layer PDL, the size of the residual space in the first trench TRC1 may be changed in various ways. Accordingly, a size of the residual space in the first trench TRC1 required to disconnect the common layer CL on the insulating layer IL and the pixel defining layer PDL and avoid disconnecting the common electrode CE on the common layer CL may be implemented. In other words, the common layer CL may be disconnected by the first trench TRC1, and the common electrode CE may not be disconnected by the first trench TRC1.

Because the common layer CL is disconnected by the first trench TRC1, current applied from the first pixel electrode PE1 corresponding to the first pixel area PX1 to the common layer CL may not leak into the common layer CL disposed on the second pixel electrode PE2. That is, current leakage between adjacent pixel areas by the common layer CL may be reduced or prevented. At the same time, the common electrode CE may not be disconnected by the first trench TRC1. For example, the common electrode CE may be disposed integrally without disconnection on an entire surface of the display area DA. Accordingly, the voltage drop (IR drop) phenomenon of the common electrode CE may be reduced or prevented.

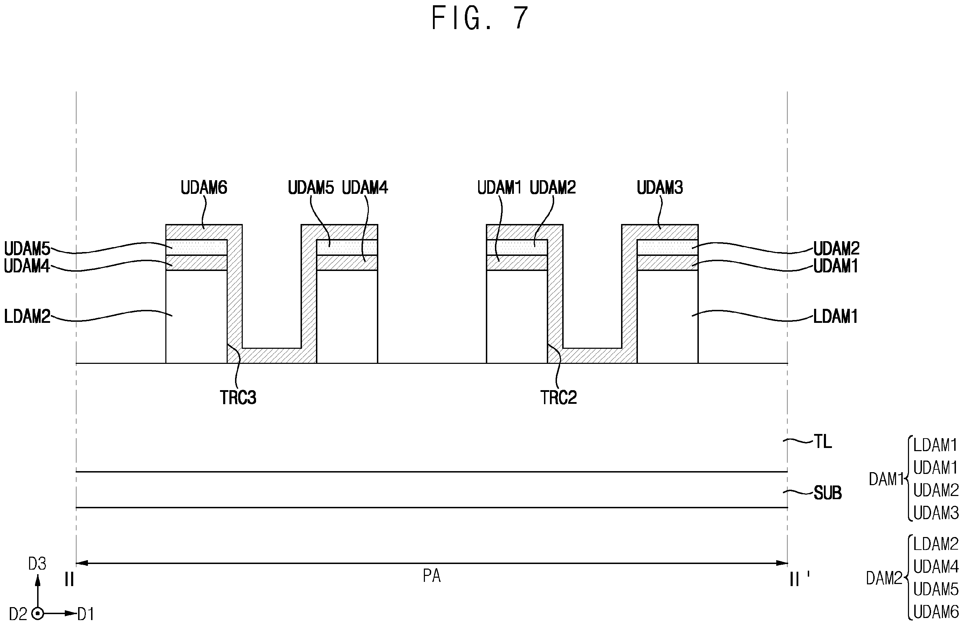

FIG. 7 is a cross-sectional view taken along the line II-II' of FIG. 1 according to one or more embodiments.

In one or more embodiments, for convenience of description, structures on the first dam DAM1 and the second dam DAM2 (e.g., thin film encapsulation layer TFE, etc.) are omitted in FIG. 7.

Referring to FIGS. 1, 6, and 7, the first dam DAM1 and the second dam DAM2 may be disposed in the peripheral area PA on the base substrate SUB. For example, the first dam DAM1 and the second dam DAM2 may be disposed on the transistor layer TL.

In one or more embodiments, the first dam DAM1 may include a first lower dam LDAM1, a first upper dam UDAM1, a second upper dam UDAM2, and a third upper dam UDAM3.

The first lower dam LDAM1 may be disposed on the transistor layer TL. The first lower dam LDAM1 may include the same material as the insulating layer IL. In other words, the first lower dam LDAM1 may be disposed on (e.g., at) the same layer as the insulating layer IL. In other words, the first lower dam LDAM1 may be formed together with the insulating layer IL in the same process. For example, the first lower dam LDAM1 may include an organic material. Examples of the organic material that can be used as the first lower dam LDAM1 may include photoresist, polyacrylic resin, polyimide resin, and/or acrylic resin. These can be used alone or in combination with each other.

In one or more embodiments, the first lower dam LDAM1 may define a second trench TRC2 around (e.g., surrounding) the display area DA. That is, the first lower dam LDAM1 may surround the display area DA, and the second trench TRC2 may penetrate an upper surface of the first lower dam LDAM1, so the second trench TRC2 may surround the display area DA. In other words, the second trench TRC2 may have a closed-loop shape. The second trench TRC2 may be formed together with the first trench TRC1 of the insulating layer IL.

FIG. 7 illustrates that the second trench TRC2 exposes the upper surface of the transistor layer TL, but the present disclosure is not necessarily limited thereto. In one or more embodiments, the second trench TRC2 may not expose the upper surface of the transistor layer TL, but may extend only from the upper surface of the first lower dam LDAM1 to inside of the first lower dam LDAM1. In one or more embodiments, the second trench TRC2 may extend from the upper surface of the first lower dam LDAM1 through the upper surface of the transistor layer TL to inside of the transistor layer TL.

The first upper dam UDAM1 may be disposed on the first lower dam LDAM1 and may be spaced from the second trench TRC2 in a plan view. That is, the first upper dam UDAM1 may not be disposed in the second trench TRC2. The first upper dam UDAM1 may include the same material as the first defining layer DL1. In other words, the first upper dam UDAM1 may be disposed on (e.g., at) the same layer as the first defining layer DL1. In other words, the first upper dam UDAM1 may be formed together with the first defining layer DL1 in the same process. For example, the first upper dam UDAM1 may include an inorganic material. For example, the first upper dam UDAM1 may include silicon oxide, silicon nitride, and/or silicon carbonitride.

The second upper dam UDAM2 may be disposed on the first upper dam UDAM1 and may be spaced from the second trench TRC2 in a plan view. That is, the second upper dam UDAM2 may not be disposed in the second trench TRC2. The second upper dam UDAM2 may include the same material as the second defining layer DL2. In other words, the second upper dam UDAM2 may be disposed on (e.g., at) the same layer as the second defining layer DL2. In other words, the second upper dam UDAM2 may be formed together with the second defining layer DL2 in the same process. For example, the second upper dam UDAM2 may include an inorganic material. In one or more embodiments, the second upper dam UDAM2 may include silicon oxide, silicon nitride, and/or silicon carbonitride.

The third upper dam UDAM3 may be disposed on the second upper dam UDAM2, extend into the second trench TRC2, and cover an inner surface of the second trench TRC2. For example, as illustrated in FIG. 7, the third upper dam UDAM3 may extend into the second trench TRC2 and cover all surfaces defining the second trench TRC2. The third upper dam UDAM3 may include the same material as the third defining layer DL3. In other words, the third upper dam UDAM3 may be disposed on (e.g., at) the same layer as the third defining layer DL3. In other words, the third upper dam UDAM3 may be formed together with the third defining layer DL3 in the same process. For example, the third upper dam UDAM3 may include an inorganic material. In one or more embodiments, the third upper dam UDAM3 may include silicon oxide, silicon nitride, and/or silicon carbonitride.

In one or more embodiments, the second dam DAM2 may include a second lower dam LDAM2, a fourth upper dam UDAM4, a fifth upper dam UDAM5, and a sixth upper dam UDAM6.

The second lower dam LDAM2 may be disposed on the transistor layer TL. The second lower dam LDAM2 may include the same material as the insulating layer IL and the first lower dam LDAM1. In other words, the second lower dam LDAM2 may be disposed on (e.g., at) the same layer as the insulating layer IL and the first lower dam LDAM1. In other words, the second lower dam LDAM2 may be formed together with the insulating layer IL and the first lower dam LDAM1 in the same process. For example, the second lower dam LDAM2 may include an organic material. Examples of the organic material that can be used as the second lower dam LDAM2 may include photoresist, polyacrylic resin, polyimide resin, and/or acrylic resin. These can be used alone or in combination with each other.

In one or more embodiments, the second lower dam LDAM2 may define a third trench TRC3 around (e.g., surrounding) the second trench TRC2. That is, the second lower dam LDAM2 may surround the first lower dam LDAM1, and the third trench TRC3 may penetrate an upper surface of the second lower dam LDAM2, so the third trench TRC3 may surround the second trench TRC2. In other words, the third trench TRC3 may have a closed-loop shape. The third trench TRC3 may be formed together with the first trench TRC1 of the insulating layer IL and the second trench TRC2 of the first lower dam LDAM1.

FIG. 7 illustrates that the third trench TRC3 exposes the upper surface of the transistor layer TL, but the present disclosure is not necessarily limited thereto. In one or more embodiments, the third trench TRC3 may not expose the upper surface of the transistor layer TL, but may extend only from the upper surface of the second lower dam LDAM2 to inside of the second lower dam LDAM2. In one or more embodiments, the third trench TRC3 may extend from the upper surface of the second lower dam LDAM2 through the upper surface of the transistor layer TL to inside of the transistor layer TL.

The fourth upper dam UDAM4 may be disposed on the second lower dam LDAM2 and may be spaced from the third trench TRC3 in a plan view. That is, the fourth upper dam UDAM4 may not be disposed in the third trench TRC3. The fourth upper dam UDAM4 may include the same material as the first defining layer DL1 and the first upper dam UDAM1. In other words, the fourth upper dam UDAM4 may be disposed on (e.g., at) the same layer as the first defining layer DL1 and the first upper dam UDAM1. In other words, the fourth upper dam UDAM4 may be formed together with the first defining layer DL1 and the first upper dam UDAM1 in the same process. For example, the fourth upper dam UDAM4 may include an inorganic material. For example, the fourth upper dam UDAM4 may include silicon oxide, silicon nitride, and/or silicon carbonitride.

The fifth upper dam UDAM5 may be disposed on the fourth upper dam UDAM4 and may be spaced from the third trench TRC3 in a plan view. That is, the fifth upper dam UDAM5 may not be disposed in the third trench TRC3. The fifth upper dam UDAM5 may include the same material as the second defining layer DL2 and the second upper dam UDAM2. In other words, the fifth upper dam UDAM5 may be disposed on (e.g., at) the same layer as the second defining layer DL2 and the second upper dam UDAM2. In other words, the fifth upper dam UDAM5 may be formed together with the second defining layer DL2 and the second upper dam UDAM2 in the same process. For example, the fifth upper dam UDAM5 may include an inorganic material. For example, the fifth upper dam UDAM5 may include silicon oxide, silicon nitride, and/or silicon carbonitride.

The sixth upper dam UDAM6 may be disposed on the fifth upper dam UDAM5, extend into the third trench TRC3, and cover an inner surface of the third trench TRC3. For example, as illustrated in FIG. 7, the sixth upper dam UDAM6 may extend into the third trench TRC3 and cover all surfaces defining the third trench TRC3. The sixth upper dam UDAM6 may include the same material as the third defining layer DL3 and the third upper dam UDAM3. In other words, the sixth upper dam UDAM3 may be disposed on (e.g., at) the same layer as the third defining layer DL3 and the third upper dam UDAM3. In other words, the sixth upper dam UDAM6 may be formed together with the third defining layer DL3 and the third upper dam UDAM3 in the same process. For example, the sixth upper dam UDAM6 may include an inorganic material. For example, the sixth upper dam UDAM6 may include silicon oxide, silicon nitride, and/or silicon carbonitride.

According to one or more embodiments, each of the first dam DAM1 and the second dam DAM2 disposed in the peripheral area PA may define a trench. Additionally, the trench may be formed together with the first trench TRC1 of the insulating layer IL. For example, the first lower dam LDAM1 of the first dam DAM1 may define the second trench TRC2 formed together with the first trench TRC1, and the second lower dam LDAM2 of the second dam DAM2 may define the third trench TRC3 formed together with the first trench TRC1. Accordingly, a phenomenon in which organic materials of the thin film encapsulation layer sealing the display area DA flows outward from each of the first dam DAM1 and the second dam DAM2 may be further reduced or prevented.

The display device DD according to one or more embodiments may be a display device that displays an image. For example, the display device DD may be a display device such as an organic light emitting display device, a liquid crystal display device, an organic light emitting diode on silicon substrate (OLEDos), a liquid crystal on silicon substrate (LCos), a light emitting diode on silicon substrate (LEDos), or the like. In one or more embodiments, the display device DD may be a display device such as OLEDos.

For example, if the display device DD is a display device such as OLEDos, the display device DD may be a head-mounted display. The head-mounted display may be worn in a form of glasses, a helmet, etc., and may be a glasses-type monitor device for virtual reality or augmented reality that is focused at a distance close to the user's eyes. However, the present disclosure is not necessarily limited thereto, and the display device DD may configure various displays.

The display device DD according to one or more embodiments may be divided into the display area DA and the peripheral area PA, and the display area DA may include the first pixel area PX1 and the second pixel area PX2. In addition, the display device DD includes the transistor layer TL including the first pixel circuit part PXC1 corresponding to the first pixel area PX1 and the second pixel circuit part PXC2 corresponding to the second pixel area PX2 and the insulating layer IL disposed on the transistor layer TL. Additionally, the insulating layer IL defines the first trench TRC1 located between the first pixel area PX1 and the second pixel area PX2. Additionally, the pixel defining layer PDL on the insulating layer IL may have a structure in which a plurality of layers are stacked, and the uppermost layer from among the plurality of layers of the pixel defining layer PDL may extend into the first trench TRC1 and may cover the inner surface of the first trench TRC1.

Accordingly, by adjusting the width of the first trench TRC1 and the thickness of the uppermost layer of the pixel defining layer PDL, the size of the residual space in the first trench TRC1 may be changed in various ways. Accordingly, a size of the residual space in the first trench TRC1 required to disconnect the common layer CL on the insulating layer IL and the pixel defining layer PDL and avoid disconnecting the common electrode CE on the common layer CL may be implemented. In other words, the common layer CL may be disconnected by the first trench TRC1, and the common electrode CE may not be disconnected by the first trench TRC1.

Accordingly, as the common layer CL is disconnected by the first trench TRC1, current applied from the first pixel electrode PE1 corresponding to the first pixel area PX1 to the common layer CL may not leak into the common layer CL disposed on the second pixel electrode PE2. That is, current leakage between adjacent pixel areas by the common layer CL may be reduced or prevented. At the same time, the common electrode CE may not be disconnected by the first trench TRC1. For example, the common electrode CE may be disposed integrally without disconnection on an entire surface of the display area DA. Accordingly, a voltage drop (IR drop) phenomenon of the common electrode CE may be reduced or prevented.

Additionally, the display device DD may include the first dam DAM1 and the second dam DAM2 disposed in the peripheral area PA, and each of the first dam DAM1 and the second dam DAM2 may define a trench formed together with the first trench TRC1 of the insulating layer IL. As each of the first dam DAM1 and the second dam DAM2 define the trench, a phenomenon in which organic materials of the organic encapsulation layer of the thin film encapsulation layer TFE sealing the display area DA flows outward from each of the first dam DAM1 and the second dam DAM2 may be further reduced or prevented.

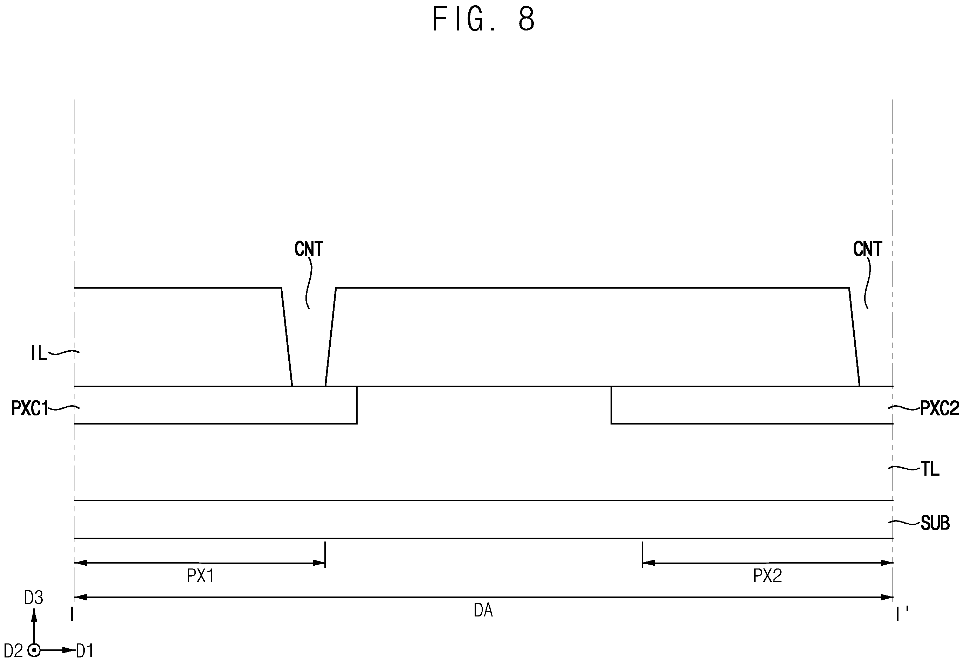

FIGS. 8 to 27 are views illustrating a method of manufacturing the display device of FIGS. 6 and 7.

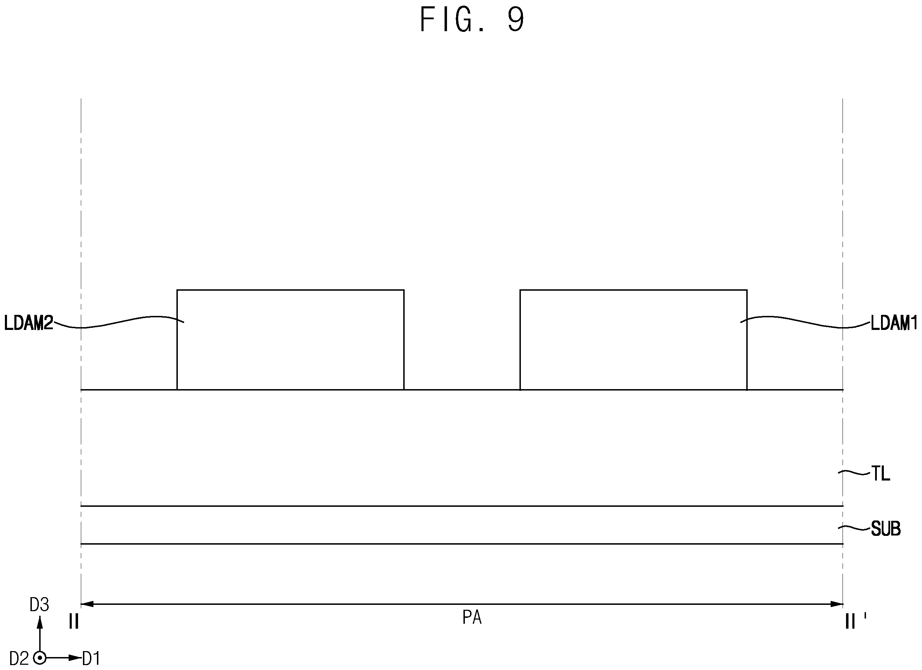

For example, FIGS. 8, 10, 11, 12, 14, 16, 18, 20, 22, 24, 26, and 27 are cross-sectional views illustrating a manufacturing process of the display device DD in the display area DA illustrated in FIG. 6. Additionally, FIGS. 9, 13, 15, 17, 19, 21, 23 and 25 are cross-sectional views illustrating a manufacturing process of the display device DD in the peripheral area PA illustrated in FIG. 7.

Referring to FIGS. 8 and 9, the transistor layer TL may be formed on the base substrate SUB. The transistor layer TL may include the first pixel circuit part PXC1 corresponding to the first pixel area PX1 and the second pixel circuit part PXC2 corresponding to the second pixel area PX2. The base substrate SUB may be formed of a silicon wafer.

The insulating layer IL, the first lower dam LDAM1, and the second lower dam LDAM2 may be formed on the transistor layer TL. That is, the insulating layer IL, the first lower dam LDAM1, and the second lower dam LDAM2 may be formed together in the same process. The insulating layer IL, the first lower dam LDAM1, and the second lower dam LDAM2 may be formed of an organic material.

A contact hole CNT may be formed by removing a portion of the insulating layer IL in each of the first pixel area PX1 and the second pixel area PX2. The contact hole CNT may expose a portion of each of the first pixel circuit portion PXC1 and the second pixel circuit portion PXC2.

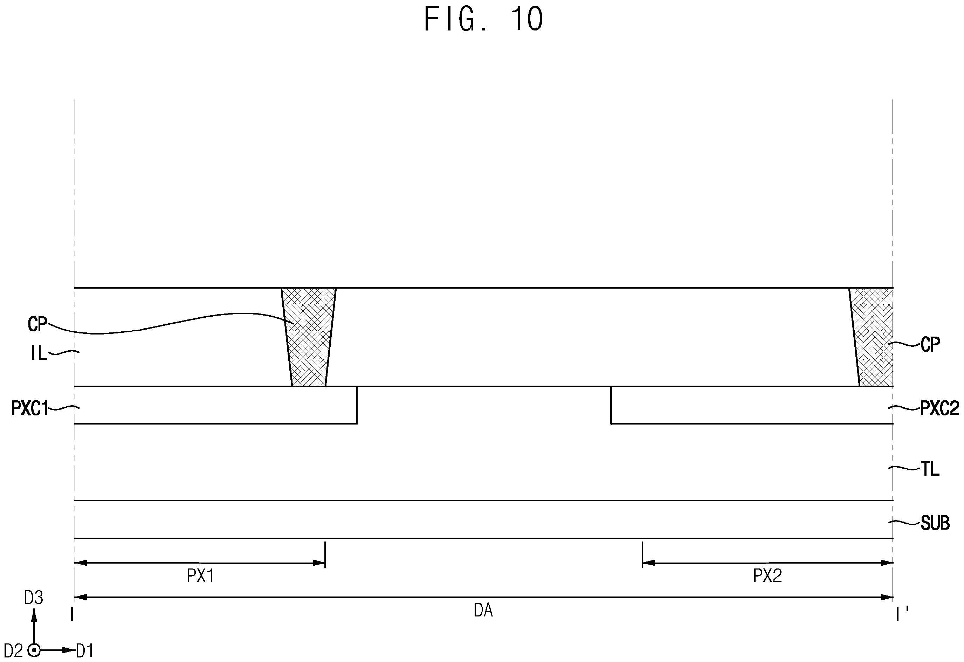

Referring further to FIG. 10, the contact hole CNT may be filled with the connection pattern CP. For example, the connection pattern CP may be formed of tungsten (W). The connection pattern CP may be electrically connected to the first pixel circuit part PXC1 and the second pixel circuit part PXC2.

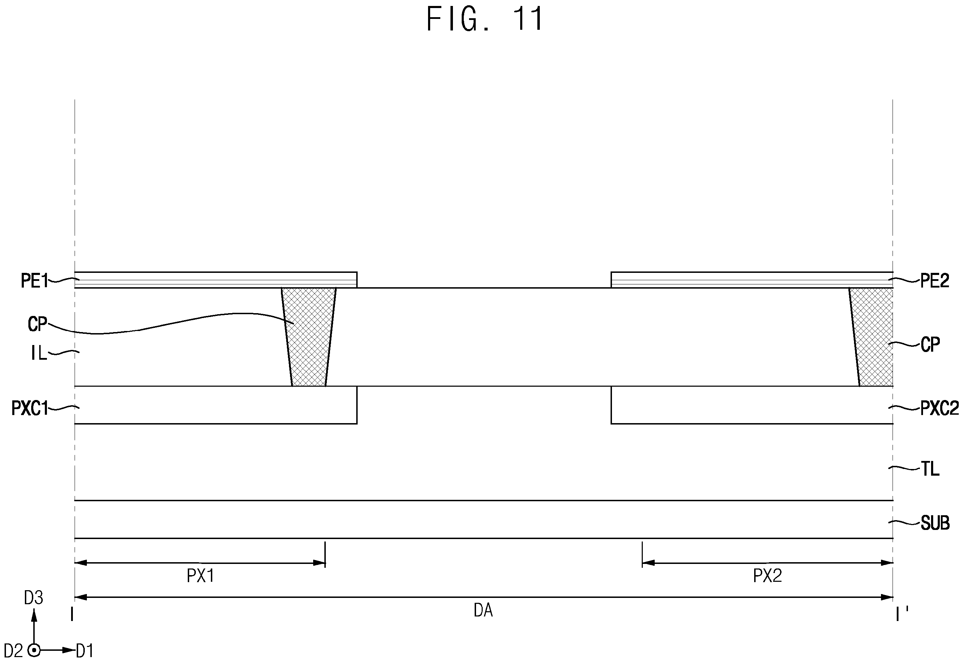

Referring further to FIG. 11, the first pixel electrode PE1 and the second pixel electrode PE2 may be formed in the display area DA on the insulating layer IL. For example, the first pixel electrode PE1 may correspond to the first pixel area PX1, and the second pixel electrode PE2 may correspond to the second pixel area PX2. The first pixel electrode PE1 and the second pixel electrode PE2 may be electrically connected to the connection pattern CP. Accordingly, the first pixel electrode PE1 may be electrically connected to the first pixel circuit part PXC1, and the second pixel electrode PE2 may be electrically connected to the second pixel circuit part PXC2.

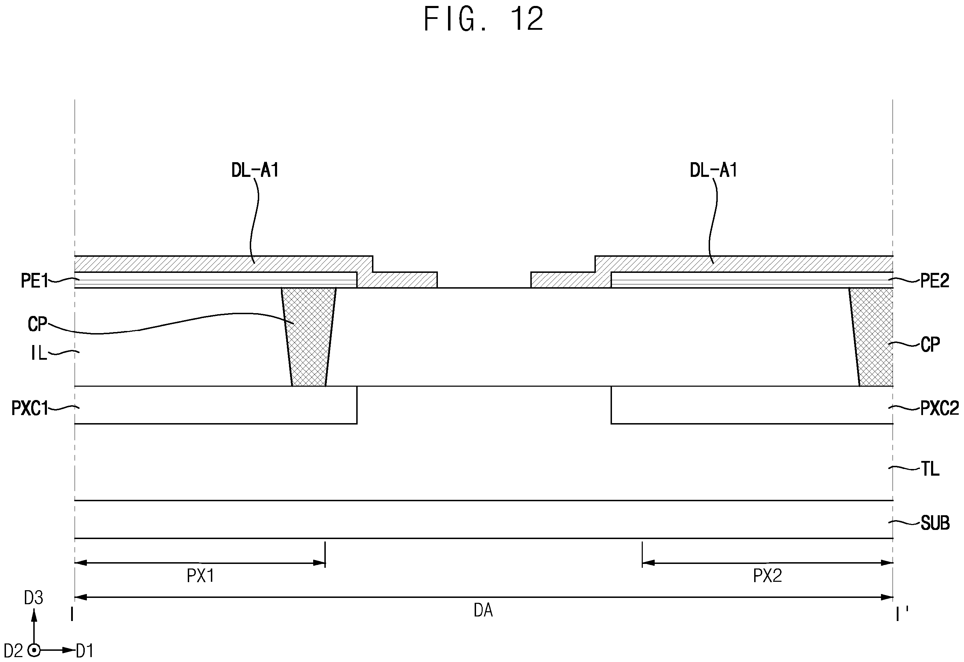

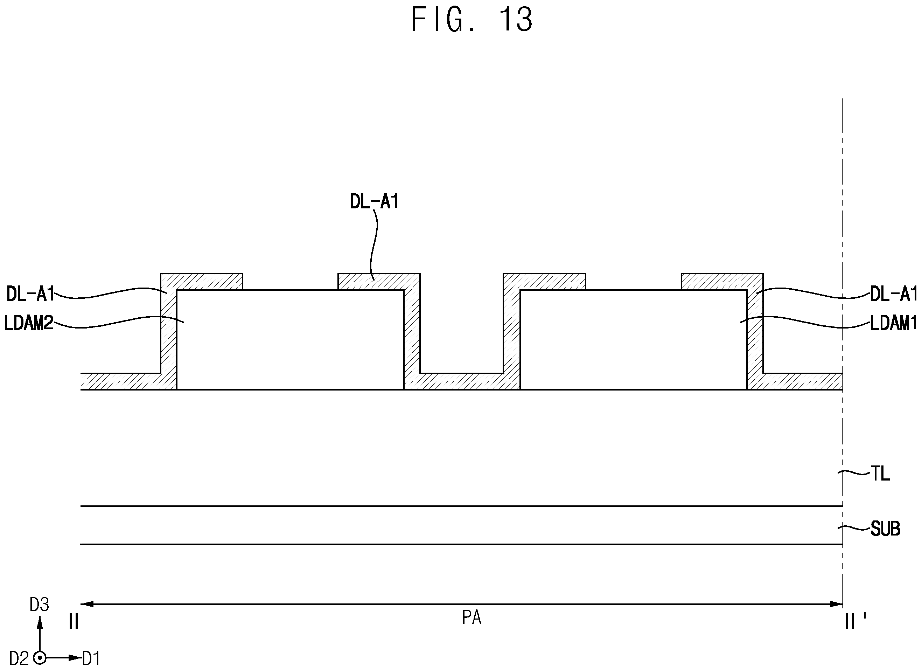

Referring further to FIGS. 12 and 13, a first preliminary defining layer DL-A1 may be formed on the insulating layer IL, the first lower dam LDAM1, and the second lower dam LDAM2. The first preliminary defining layer DL-A1 may cover the first pixel electrode PE1 and the second pixel electrode PE2. The first preliminary defining layer DL-A1 may expose a portion of the insulating layer IL, a portion of the first lower dam LDAM1, and a portion of the second lower dam LDAM2. The first preliminary defining layer DL-A1 may be formed of an inorganic material. For example, the first preliminary defining layer DL-A1 may be formed of silicon oxide, silicon nitride, and/or silicon carbonitride.

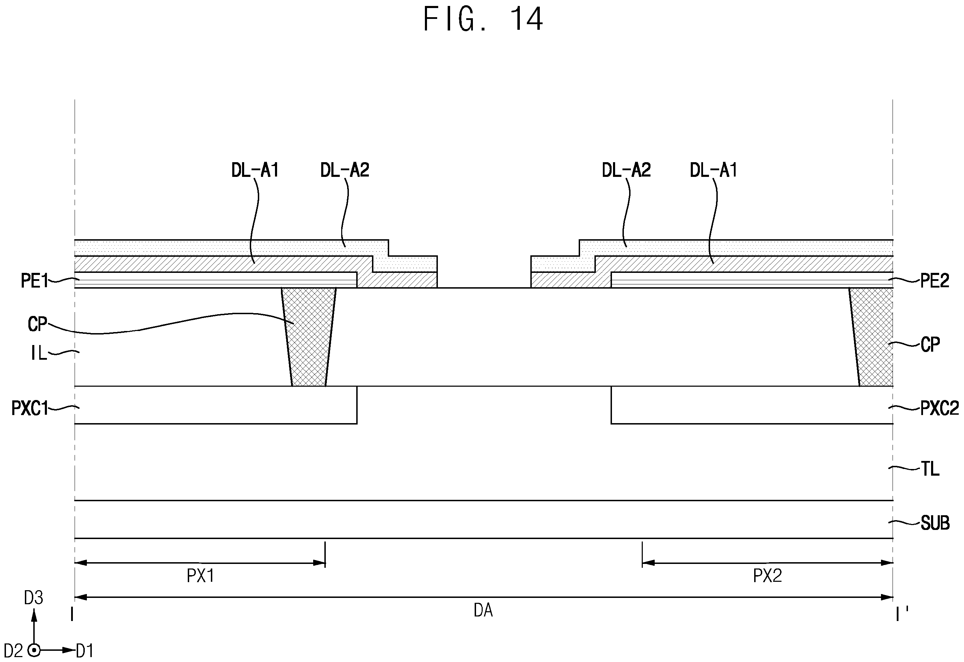

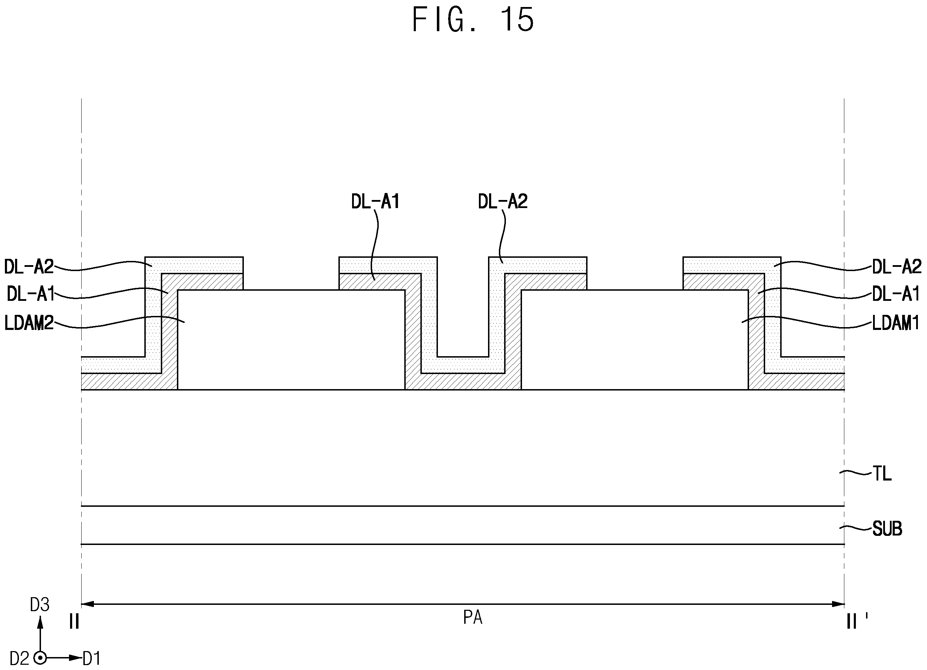

Referring further to FIGS. 14 and 15, the second preliminary defining layer DL-A2 may be formed on the first preliminary defining layer DL-A1. The second preliminary defining layer DL-A2 may cover the first preliminary defining layer DL-A1. The second preliminary defining layer DL-A2 may expose a portion of the insulating layer IL, a portion of the first lower dam LDAM1, and a portion of the second lower dam LDAM2. The second preliminary defining layer DL-A2 may be formed of an inorganic material. For example, the second preliminary defining layer DL-A2 may be formed of silicon oxide, silicon nitride, and/or silicon carbonitride.

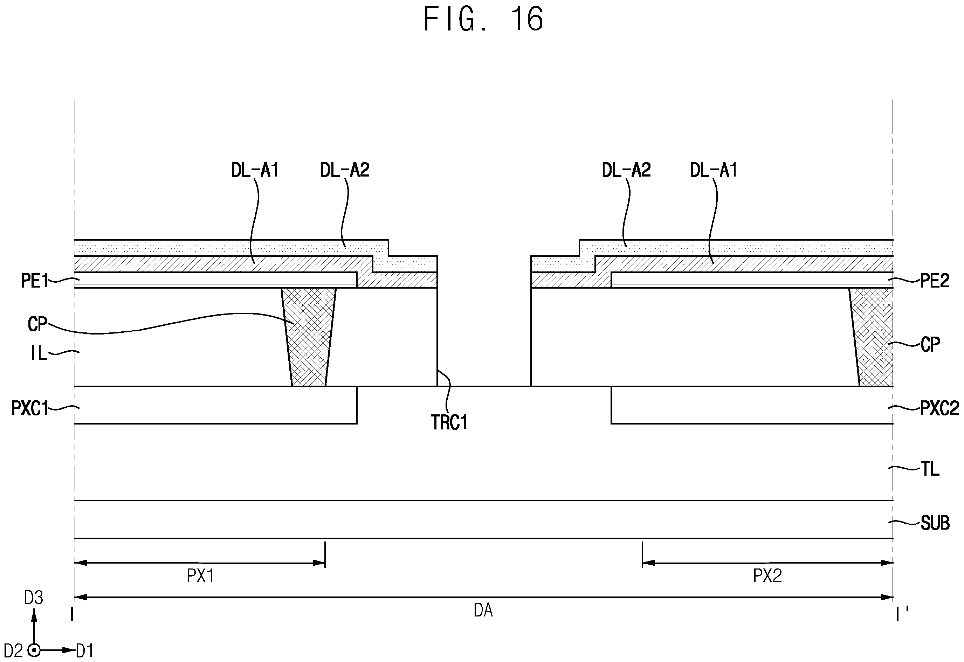

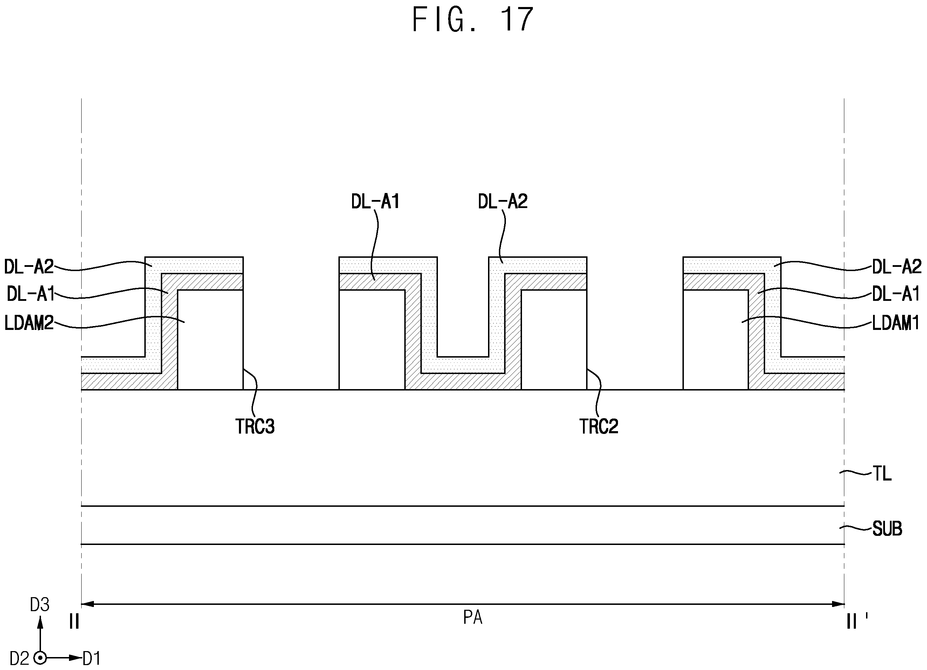

Referring further to FIGS. 16 and 17, the portion of the insulating layer IL may be removed to form the first trench TRC1. That is, the first trench TRC1 may be formed by removing the portion of the insulating layer IL exposed from the first preliminary defining layer DL-A1 and the second preliminary defining layer DL-A2. Additionally, the portion of the first lower dam LDAM1 may be removed to form the second trench TRC2. That is, the second trench TRC2 may be formed by removing the portion of the first lower dam LDAM1 exposed from the first preliminary defining layer DL-A1 and the second preliminary defining layer DL-A2. Additionally, the portion of the second lower dam LDAM2 may be removed to form the third trench TRC3. That is, the third trench TRC3 may be formed by removing the portion of the second lower dam LDAM2 exposed from the first preliminary defining layer DL-A1 and the second preliminary defining layer DL-A2. That is, the first trench TRC1, the second trench TRC2, and the third trench TRC3 may be formed together in the same process.

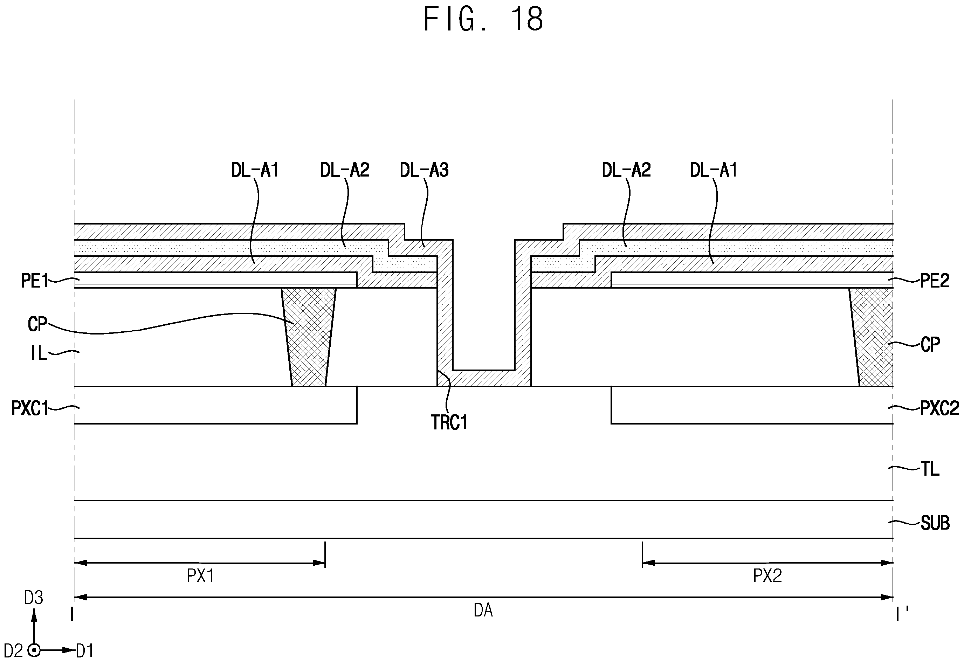

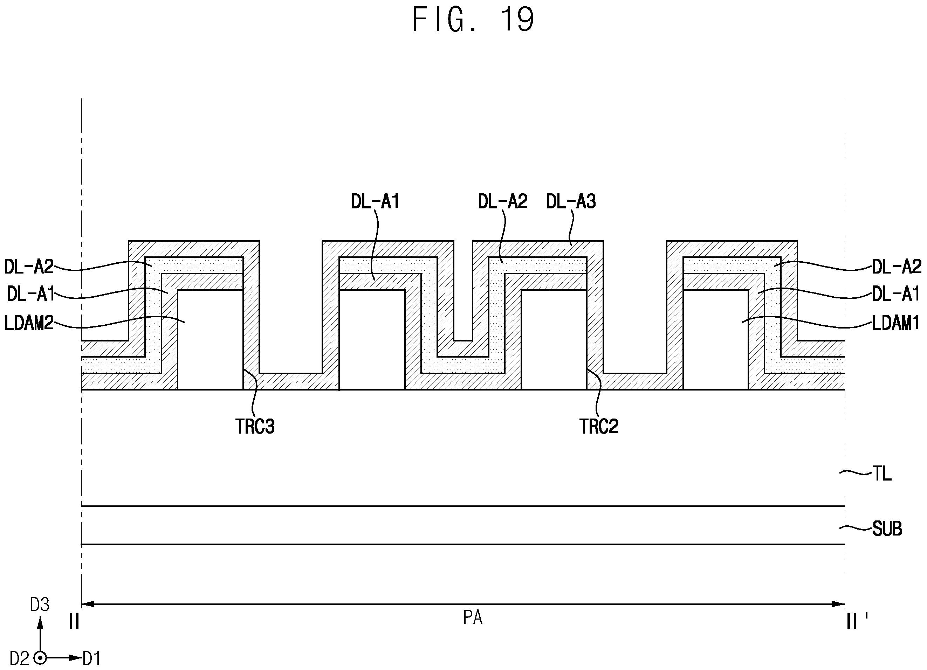

Referring further to FIGS. 18 and 19, a third preliminary defining layer DL-A3 may be formed on the insulating layer IL, the first lower dam LDAM1, the second lower dam LDAM2, and the second preliminary defining layer DL-A2. The third preliminary defining layer DL-A3 may cover the insulating layer IL, the first lower dam LDAM1, the second lower dam LDAM2, and the second preliminary defining layer DL-A2. The third preliminary defining layer DL-A3 may be formed of an inorganic material. For example, the third preliminary defining layer DL-A3 may be formed of silicon oxide, silicon nitride, and/or silicon carbonitride.

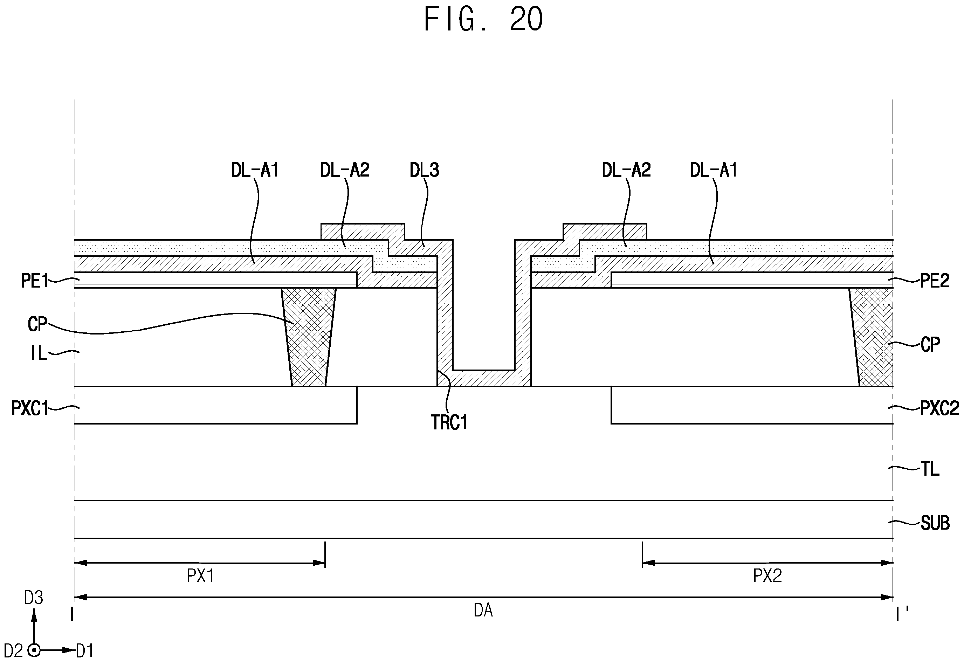

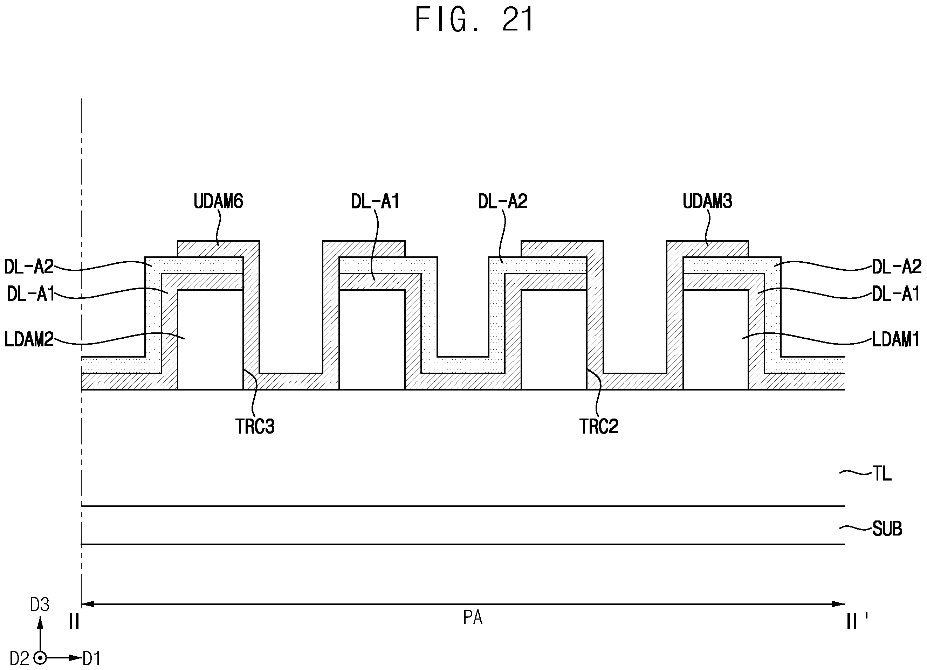

Referring further to FIGS. 20 and 21, the third defining layer DL3, the third upper dam UDAM3, the sixth upper dam UDAM6 may be formed by removing a portion of the third preliminary defining layer DL-A3. That is, the third defining layer DL3, the third upper dam UDAM3, and the sixth upper dam UDAM6 may be formed together in the same process. The third defining layer DL3 may extend into the first trench TRC1 and may cover the inner surface of the first trench TRC1. The third upper dam UDAM3 may extend into the second trench TRC2 and may cover the inner surface of the second trench TRC2. The sixth upper dam UDAM6 may extend into the third trench TRC3 and may cover the inner surface of the third trench TRC3.

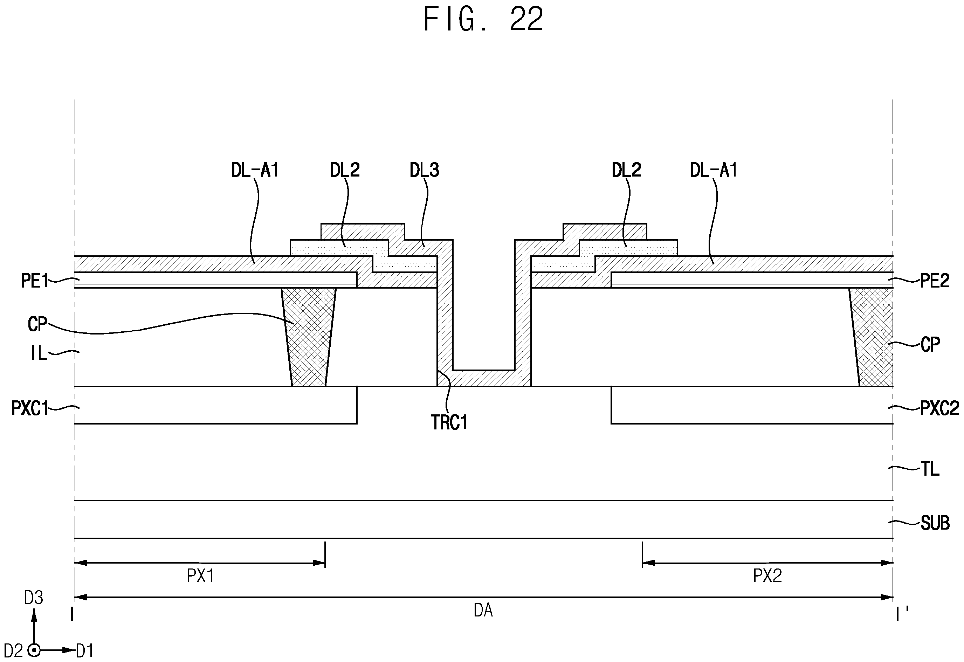

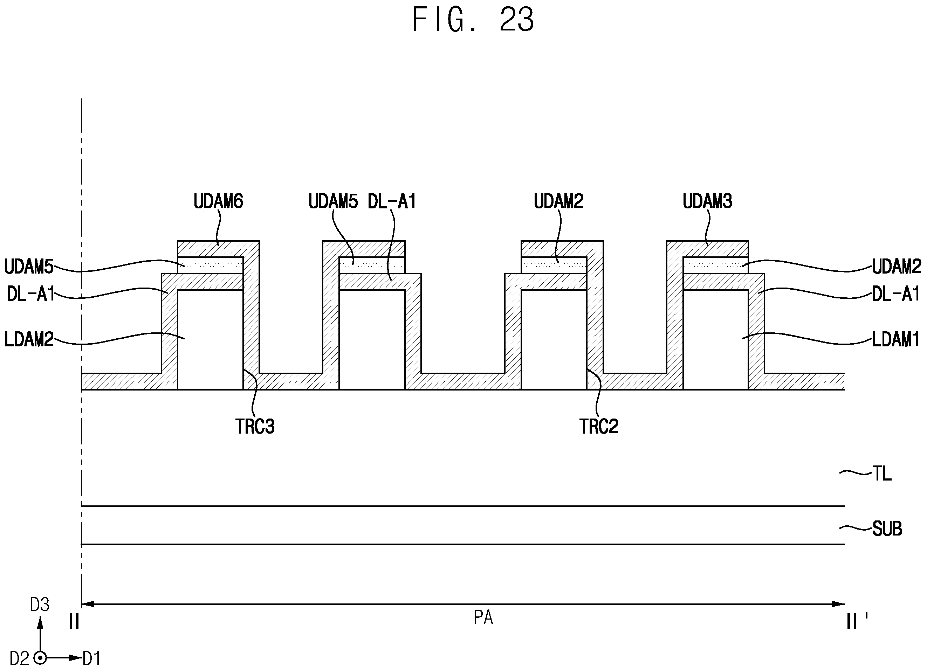

Referring further to FIGS. 22 and 23, the second defining layer DL2, the second upper dam UDAM2, the fifth upper dam UDAM5 may be formed by removing a portion of the second preliminary defining layer DL-A2. That is, the second defining layer DL2, the second upper dam UDAM2, and the fifth upper dam UDAM5 may be formed together in the same process. The second defining layer DL2 may be spaced from the first trench TRC1 in a plan view. The second upper dam UDAM2 may be spaced from the second trench TRC2 in a plan view. The fifth upper dam UDAM5 may be spaced from the third trench TRC3 in a plan view.

In one or more embodiments, the second defining layer DL2 may be formed such that a portion of the second defining layer DL2 is exposed from the third defining layer DL3. That is, an end of the second defining layer DL2 and an end of the third defining layer DL3 may define a step-shaped step.

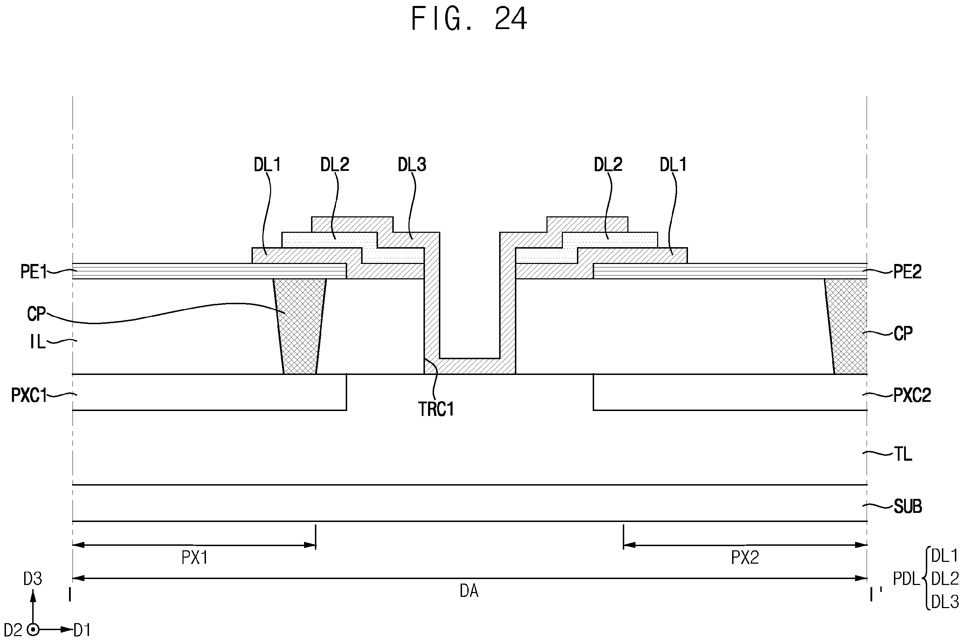

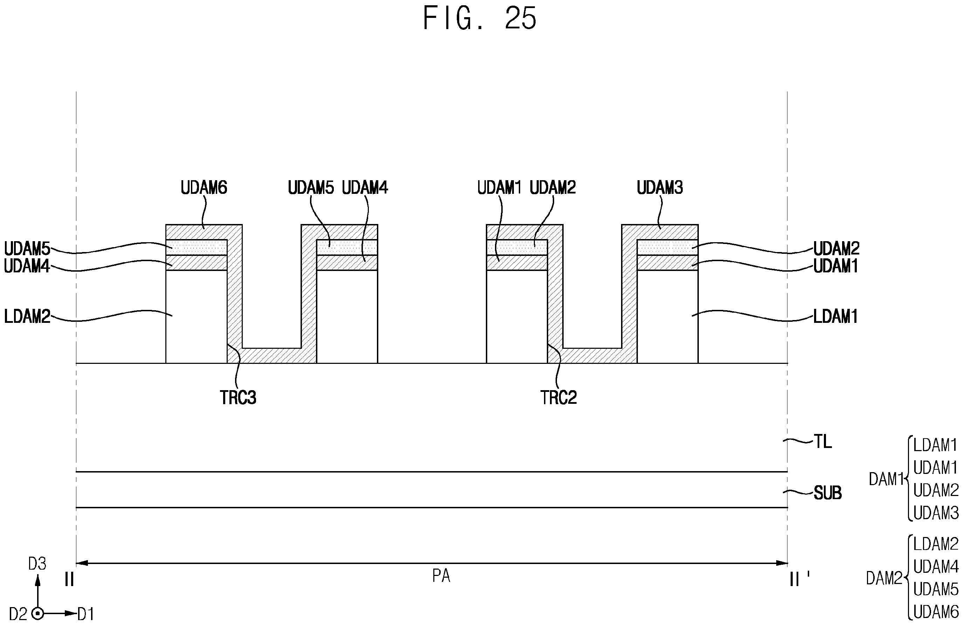

Referring further to FIGS. 24 and 25, the first defining layer DL1, the first upper dam UDAM1, the fourth upper dam UDAM4 may be formed by removing a portion of the first preliminary defining layer DL-A1. That is, the first defining layer DL1, the first upper dam UDAM1, and the fourth upper dam UDAM4 may be formed together in the same process. The first defining layer DL1 may be spaced from the first trench TRC1 in a plan view. The first upper dam UDAM1 may be spaced from the second trench TRC2 in a plan view. The fourth upper dam UDAM4 may be spaced from the third trench TRC3 in a plan view.

In one or more embodiments, the first defining layer DL1 may be formed such that a portion of the first defining layer DL1 is exposed from the second defining layer DL2. That is, an end of the first defining layer DL1 and an end of the second defining layer DL2 may define a step-shaped step.

As a result, the first defining layer DL1, the second defining layer DL2, and the third defining layer DL3 may be sequentially stacked on the insulating layer IL to form the pixel defining layer PDL. That is, the pixel defining layer PDL covering a side portion of each of the first pixel electrode PE1 and the second pixel electrode PE2, and exposing a central portion of each of the first pixel electrode PE1 and the second pixel electrode PE2 may be formed. The pixel defining layer PDL may extend into the first trench TRC1 and may cover the inner surface of the first trench TRC1. In addition, the first lower dam LDAM1, the first upper dam UDAM1, the second upper dam UDAM2, and the third upper dam UDAM3 may be sequentially stacked in the peripheral area PA to form the first dam DAM1. In addition, the second lower dam LDAM2, the fourth upper dam UDAM4, the fifth upper dam UDAM5, and the sixth upper dam UDAM6 may be sequentially stacked in the peripheral area PA to form the second dam DAM2.

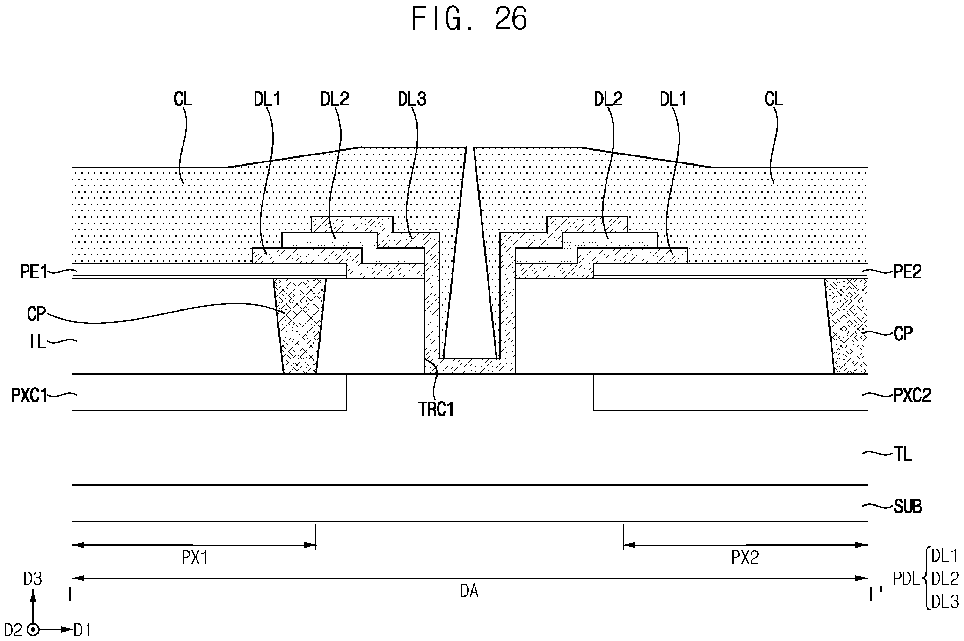

Referring further to FIG. 26, the common layer CL may be formed on the insulating layer IL and the pixel defining layer PDL. As illustrated in FIG. 26, the common layer CL may be disconnected by the first trench TRC1. For example, by adjusting the width of the first trench TRC1 in the process of forming the first trench TRC1 and adjusting the thickness of the third defining layer DL3 in the process of forming the third defining layer DL3, a size of the residual space in the first trench TRC1 required to disconnect the common layer CL may be implemented. Accordingly, the common layer CL may be disconnected by the first trench TRC1. As the common layer CL is disconnected, current leakage due to the common layer CL may be reduced or prevented.

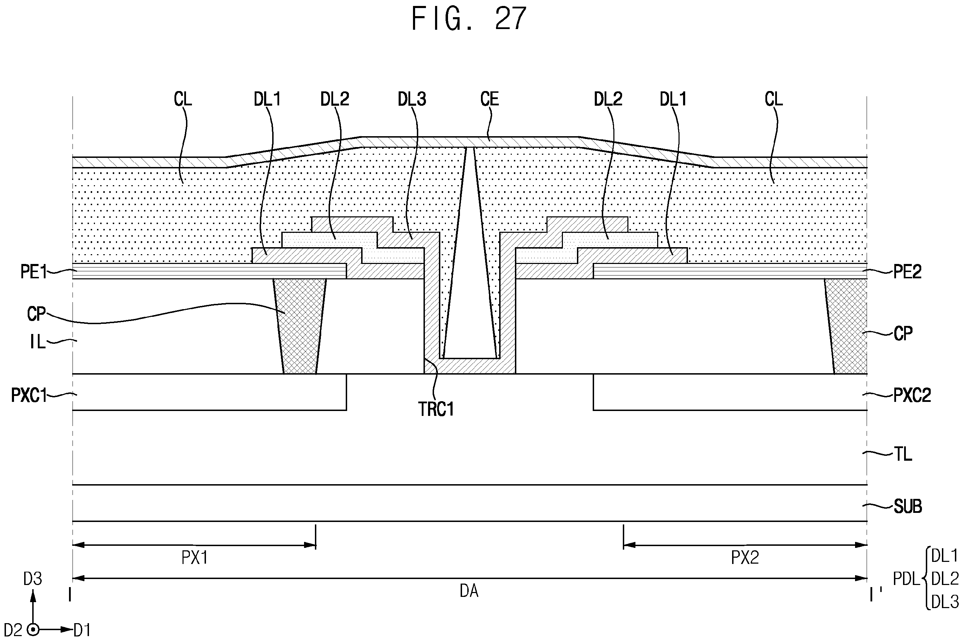

Referring further to FIG. 27, the common electrode CE may be formed on the common layer CL. As illustrated in FIG. 26, the common electrode CE may not be disconnected by the first trench TRC1. For example, by adjusting the width of the first trench TRC1 in the process of forming the first trench TRC1 and adjusting the thickness of the third defining layer DL3 in the process of forming the third defining layer DL3, a size of the residual space in the first trench TRC1 required to avoid disconnecting the common electrode CE may be implemented. Accordingly, the common electrode CE may not be disconnected by the first trench TRC1. By forming the common electrode CE as a plate electrode, a voltage drop phenomenon of the common electrode CE may be reduced or prevented.

As a result, according to the manufacturing method of the display device DD according to one or more embodiments, by adjusting the width of the first trench TRC1 and the thickness of the uppermost layer of the pixel defining layer PDL, a size of the residual space in the first trench TRC1 may be changed in various ways. Accordingly, a size of the residual space in the first trench TRC1 required to disconnect the common layer CL on the insulating layer IL and the pixel defining layer PDL and avoid disconnecting the common electrode CE on the common layer CL may be implemented. In other words, the common layer CL may be formed to be disconnected by the first trench TRC1, and the common electrode CE may be formed not to be disconnected by the first trench TRC1. Accordingly, current leakage by the common layer CL may be reduced or prevented, and at the same time, a voltage drop phenomenon of the common electrode CE may be reduced or prevented.

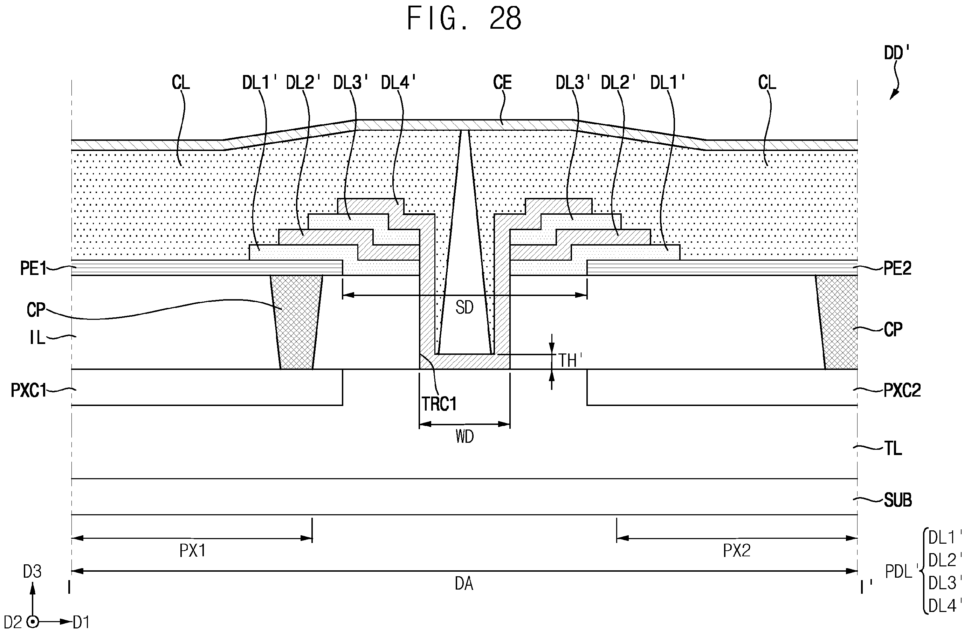

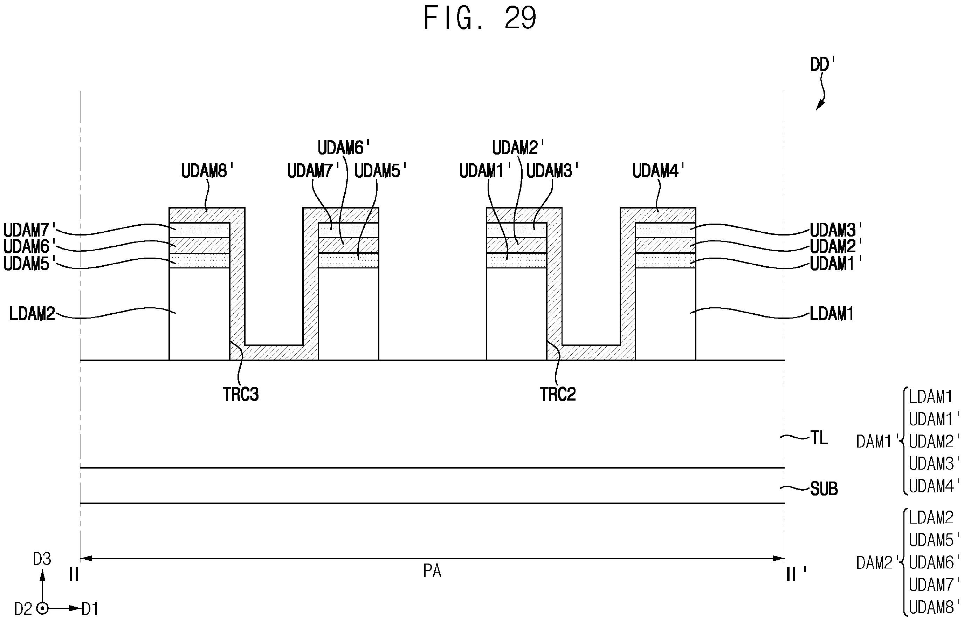

FIG. 28 is a cross-sectional view taken along the line I-I' of FIG. 4 according to one or more embodiments, and FIG. 29 is a cross-sectional view taken along the line II-II' of FIG. 1 according to one or more embodiments.

That is, FIG. 28 may correspond to the cross-sectional view of FIG. 6, and FIG. 29 may correspond to the cross-sectional view of FIG. 7.

A display device DD' described with reference to FIGS. 28 and 29 may be substantially same as the display device illustrated in FIGS. 6 and 7 except for including a pixel defining layer PDL', a first dam DAM1', and a second dam DAM2'. That is, the display device DD' may include the pixel defining layer PDL', the first dam DAM1', and the second dam DAM2' instead of the pixel defining layer PDL, the first dam DAM1, and the second dam DAM2. In addition, the pixel defining layer PDL', the first dam DAM1', and the second dam DAM2' described with reference to FIGS. 6 and 7 may be substantially same as the pixel defining layer PDL, the first dam DAM1, and the second dam DAM2 the except for a layer-structure. Therefore, hereinafter, descriptions that overlap with those of the display device DD will be omitted or simplified.

Referring to FIG. 28, the pixel defining layer PDL' may have a four-layer structure in which a first defining layer DL1', a second defining layer DL2', a third defining layer DL3', and a fourth defining layer DL4' are sequentially stacked.

The first defining layer DL1' may be disposed on the insulating layer IL, the first pixel electrode PE1, and the second pixel electrode PE2, and spaced from the first trench TRC1 in a plan view. That is, the first defining layer DL1' may not be disposed inside the first trench TRC1. In one or more embodiments, the first defining layer DL1' may include an inorganic material. For example, the first defining layer DL1' may include silicon oxide, silicon nitride, and/or silicon carbonitride.

The second defining layer DL2' may be disposed on the first defining layer DL1' and may be spaced from the first trench TRC1 in a plan view. That is, the second defining layer DL2' may not be disposed inside the first trench TRC1. In one or more embodiments, the second defining layer DL2' may include an inorganic material. For example, the second defining layer DL2' may include silicon oxide, silicon nitride, and/or silicon carbonitride.

In one or more embodiments, the second defining layer DL2' may expose a portion of the first defining layer DL1'. That is, an end of the first defining layer DL1' and an end of the second defining layer DL2' may define a step-shaped step.

The third defining layer DL3' may be disposed on the second defining layer DL2' and may be spaced from the first trench TRC1 in a plan view. That is, the third defining layer DL3' may not be disposed inside the first trench TRC1. In one or more embodiments, the third defining layer DL3' may include an inorganic material. For example, the third defining layer DL3' may include silicon oxide, silicon nitride, and/or silicon carbonitride.

In one or more embodiments, the third defining layer DL3' may expose a portion of the second defining layer DL2'. That is, the end of the second defining layer DL2' and an end of the third defining layer DL3' may define a step-shaped step.

The fourth defining layer DL4' may be disposed on the third defining layer DL3', extend into the first trench TRC1, and cover the inner surface of the first trench TRC1. For example, as illustrated in FIG. 28, the fourth defining layer DL4' may extend into the first trench TRC1 and cover all surfaces defining the first trench TRC1. In other words, as the fourth defining layer DL4' extends into the first trench TRC1 and covers the inner surface of the first trench TRC1, the pixel defining layer PDL' may extend into the first trench TRC1 and cover the inner surface of the first trench TRC1.

In one or more embodiments, the fourth defining layer DL4' may expose a portion of the third defining layer DL3'. That is, the end of the third defining layer DL3' and an end of the fourth defining layer DL4' may define a step-shaped step. Accordingly, a side surface of the pixel defining layer PDL' may have a step-shaped step. Accordingly, a step coverage of the common layer CL and the common electrode CE formed on the pixel defining layer PDL' may be improved. Accordingly, durability of the display device DD' may be improved.

A thickness TH' of the fourth defining layer DL4' may be smaller than the width WD of the first trench TRC1. That is, even when the fourth defining layer DL4' covers the inner surface of the first trench TRC1, residual space may still remain in the first trench TRC1.

In one or more embodiments, as illustrated in FIG. 28, the pixel defining layer PDL' may have a structure in which the first defining layer DL1', the second defining layer DL2', the third defining layer DL3', and the fourth defining layer DL4' are sequentially stacked. For example, the pixel defining layer PDL' may have a four-layer structure in which the first defining layer DL1' including silicon oxide, the second defining layer DL2' including silicon nitride, the third defining layer DL3' including silicon oxide, and the fourth defining layer DL4' including silicon nitride are sequentially stacked. In addition, the pixel defining layer PDL' may have a four-layer structure in which the first defining layer DL1' including silicon oxide, the second defining layer DL2' including silicon carbonitride, the third defining layer DL3' including silicon oxide, and the fourth defining layer DL4' including silicon carbonitride are sequentially stacked. In addition, the pixel defining layer PDL' may have a four-layer structure in which the first defining layer DL1' including silicon nitride, the second defining layer DL2' including silicon oxide, the third defining layer DL3' including silicon oxide, and the fourth defining layer DL4' including silicon nitride are sequentially stacked. However, this is only an example, and a stacked structure of the pixel defining layer PDL' and materials of each layer constituting the pixel defining layer PDL' may be variously changed according to one or more embodiments.

Referring to FIG. 29, in one or more embodiments, the first dam DAM1' may include the first lower dam LDAM1, a first upper dam UDAM1', a second upper dam UDAM2', a third upper dam UDAM3', and a fourth upper dam UDAM4'. Hereinafter, the description of the first lower dam LDAM1 is omitted because it overlaps with the content described with reference to FIG. 7.

The first upper dam UDAM1' may be disposed on the first lower dam LDAM1 and may be spaced from the second trench TRC2 in a plan view. That is, the first upper dam UDAM1' may not be disposed in the second trench TRC2. The first upper dam UDAM1' may include the same material as the first defining layer DL1'. In other words, the first upper dam UDAM1' may be disposed on (e.g., at) the same layer as the first defining layer DL1'. In other words, the first upper dam UDAM1' may be formed together with the first defining layer DL1' in the same process. For example, the first upper dam UDAM1' may include an inorganic material. For example, the first upper dam UDAM1' may include silicon oxide, silicon nitride, and/or silicon carbonitride.

The second upper dam UDAM2' may be disposed on the first upper dam UDAM1' and may be spaced from the second trench TRC2 in a plan view. That is, the second upper dam UDAM2' may not be disposed in the second trench TRC2. The second upper dam UDAM2' may include the same material as the second defining layer DL2'. In other words, the second upper dam UDAM2' may be disposed on (e.g., at) the same layer as the second defining layer DL2'. In other words, the second upper dam UDAM2' may be formed together with the second defining layer DL2' in the same process. For example, the second upper dam UDAM2' may include an inorganic material. For example, the second upper dam UDAM2' may include silicon oxide, silicon nitride, and/or silicon carbonitride.

The third upper dam UDAM3' may be disposed on (e.g., at) the second upper dam UDAM2' and may be spaced from the second trench TRC2 in a plan view. That is, the third upper dam UDAM3' may not be disposed in the second trench TRC2. The third upper dam UDAM3' may include the same material as the third defining layer DL3'. In other words, the third upper dam UDAM3' may be disposed on (e.g., at) the same layer as the third defining layer DL3'. In other words, the third upper dam UDAM3' may be formed together with the third defining layer DL3' in the same process. For example, the third upper dam UDAM3' may include an inorganic material. For example, the third upper dam UDAM3' may include silicon oxide, silicon nitride, and/or silicon carbonitride.

The fourth upper dam UDAM4' may be disposed on the third upper dam UDAM3', extend into the second trench TRC2, and cover an inner surface of the second trench TRC2. For example, as illustrated in FIG. 29, the fourth upper dam UDAM4' may extend into the second trench TRC2 and cover all surfaces defining the second trench TRC2. The fourth upper dam UDAM4' may include the same material as the fourth defining layer DL4'. In other words, the fourth upper dam UDAM4' may be disposed on (e.g., at) the same layer as the fourth defining layer DL4'. In other words, the fourth upper dam UDAM4' may be formed together with the fourth defining layer DL4' in the same process. For example, the fourth upper dam UDAM4' may include an inorganic material. For example, the fourth upper dam UDAM4' may include silicon oxide, silicon nitride, and/or silicon carbonitride.

In one or more embodiments, the second dam DAM2' may include the second lower dam LDAM2, a fifth upper dam UDAM5', a sixth upper dam UDAM6', a seventh upper dam UDAM7', and an eight upper dam UOAM8'. Hereinafter, the description of the second lower dam LDAM2 is omitted because it overlaps with the content described with reference to FIG. 7.

The fifth upper dam UDAM5' may be disposed on the second lower dam LDAM2 and may be spaced from the third trench TRC3 in a plan view. That is, the fifth upper dam UDAM5' may not be disposed in the third trench TRC3. The fifth upper dam UDAM5' may include the same material as the first defining layer DL1' and the first upper dam UDAM1'. In other words, the fifth upper dam UDAM5' may be disposed on (e.g., at) the same layer as the first defining layer DL1' and the first upper dam UDAM1'. In other words, the fifth upper dam UDAM5' may be formed together with the first defining layer DL1' and the first upper dam UDAM1' in the same process. For example, the fifth upper dam UDAM5' may include an inorganic material. For example, the fifth upper dam UDAM5' may include silicon oxide, silicon nitride, and/or silicon carbonitride.

The sixth upper dam UDAM6' may be disposed on the fifth upper dam UDAM5' and may be spaced from the third trench TRC3 in a plan view. That is, the sixth upper dam UDAM6' may not be disposed in the third trench TRC3. The sixth upper dam UDAM6' may include the same material as the second defining layer DL2' and the second upper dam UDAM2'. In other words, the sixth upper dam UDAM6' may be disposed on (e.g., at) the same layer as the second defining layer DL2' and the second upper dam UDAM2'. In other words, the sixth upper dam UDAM6' may be formed together with the second defining layer DL2' and the second upper dam UDAM2' in the same process. For example, the sixth upper dam UDAM6' may include an inorganic material. Specifically, the sixth upper dam UDAM6' may include silicon oxide, silicon nitride, and/or silicon carbonitride.

The seventh upper dam UDAM7' may be disposed on the sixth upper dam UDAM6' and may be spaced from the third trench TRC3 in a plan view. That is, the seventh upper dam UDAM7' may not be disposed in the third trench TRC3. The seventh upper dam UDAM7' may include the same material as the third defining layer DL3' and the third upper dam UDAM3'. In other words, the seventh upper dam UDAM7' may be disposed on (e.g., at) the same layer as the third defining layer DL3' and the third upper dam UDAM3'. In other words, the seventh upper dam UDAM7' may be formed together with the third defining layer DL3' and the third upper dam UDAM3' in the same process. For example, the seventh upper dam UDAM7' may include an inorganic material. For example, the seventh upper dam UDAM7' may include silicon oxide, silicon nitride, and/or silicon carbonitride.

The eight upper dam UDAM8' may be disposed on (e.g., at) the seventh upper dam UDAM7', extend into the third trench TRC3, and cover an inner surface of the third trench TRC3. For example, as illustrated in FIG. 29, the eight upper dam UDAM8' may extend into the third trench TRC3 and cover all surfaces defining the third trench TRC3. The eight upper dam UDAM8' may include the same material as the fourth defining layer DL4' and the fourth upper dam UDAM4'. In other words, the eight upper dam UDAM8' may be disposed on (e.g., at) the same layer as the fourth defining layer DL4' and the fourth upper dam UDAM4'. In other words, the eight upper dam UDAM8' may be formed together with the fourth defining layer DL4' and the fourth upper dam UDAM4' in the same process. For example, the eight upper dam UDAM8' may include an inorganic material. For example, the eight upper dam UDAM8' may include silicon oxide, silicon nitride, and/or silicon carbonitride.

The present disclosure may not be construed as being limited to the embodiments set forth herein. Rather, these embodiments are provided so that the present disclosure will be thorough and complete and will fully convey the concept of the present disclosure to those skilled in the art.

While the present disclosure has been particularly shown and described with reference to embodiments thereof, it will be understood by those of ordinary skill in the art that various changes in form and details may be made therein without departing from the scope of the present disclosure as defined by the following claims.

The present invention will now be defined with reference to the following clauses.
Clause 1. A display device comprising:
   a base substrate including a display area including a first pixel area and a second pixel area, and a peripheral area around the display area;
   a transistor layer on the base substrate and comprising a first pixel circuit part corresponding to the first pixel area and a second pixel circuit part corresponding to the second pixel area;
   an insulating layer disposed on the transistor layer and having contact holes exposing the first pixel circuit part and the second pixel circuit part and a first trench located between the first pixel area and the second pixel area;
   a first pixel electrode located at the first pixel area on the insulating layer and electrically connected to the first pixel circuit part;
   a second pixel electrode located at the second pixel area on the insulating layer and electrically connected to the second pixel circuit part; and
   a pixel defining layer on the insulating layer, the first pixel electrode, and the second pixel electrode, exposing a portion of each of the first pixel electrode and the second pixel electrode, extending into the first trench, and covering an inner surface of the first trench.
Clause 2. The display device of clause 1, wherein the pixel defining layer comprises:
   a first defining layer on the insulating layer and spaced from the first trench in a plan view;
   a second defining layer on the first defining layer and spaced from the first trench in a plan view; and
   a third defining layer on the second defining layer, extending into the first trench, and covering the inner surface of the first trench.
Clause 3. The display device of clause 2, wherein the insulating layer comprises an organic material, and
   wherein each of the first defining layer, the second defining layer, and the third defining layer comprises at least one of silicon oxide, silicon nitride, or silicon carbonitride.
Clause 4. The display device of clause 2 or clause 3, wherein, in a cross-sectional view, a width of the first trench is smaller than a separation distance between the first pixel electrode and the second pixel electrode, and
   wherein a thickness of the third defining layer is smaller than the width of the first trench.
Clause 5. The display device of any one of clauses 2 to 4, wherein a side surface of the pixel defining layer has a step-shaped step.
Clause 6. The display device of any one of clauses 1 to 5, further comprising:
   a common layer on the insulating layer and the pixel defining layer and disconnected by the first trench; and
   a common electrode on the common layer and not disconnected by the first trench.
Clause 7. The display device of clause 6, wherein the common layer comprises:
   a first hole transport layer;
   a first light emitting layer on the first hole transport layer;
   a first electron transport layer on the first light emitting layer;
   a first charge generation layer on the first electron transport layer;
   a second hole transport layer on the first charge generation layer;
   a second light emitting layer on the second hole transport layer;
   a second electron transport layer on the second light emitting layer;
   a second charge generation layer on the second electron transport layer;
   a third hole transport layer on the second charge generation layer;
   a third light emitting layer on the third hole transport layer; and
   a third electron transport layer on the third light emitting layer.
Clause 8. The display device of any one of clauses 1 to 7, further comprising:
   a first dam in the peripheral area and surrounding the display area; and
   a second dam in the peripheral area and surrounding the first dam, and
   wherein the first dam comprises:
      a first lower dam comprising a same material as the insulating layer and having a second trench surrounding the display area;
      a first upper dam on the first lower dam and spaced from the second trench in a plan view;
      a second upper dam on the first upper dam and spaced from the second trench in a plan view; and
      a third upper dam on the second upper dam, extending into the second trench, and covering an inner surface of the second trench.
Clause 9. The display device of clause 8, wherein the first lower dam comprises an organic material, and
   wherein each of the first upper dam, the second upper dam, and the third upper dam comprises at least one of silicon oxide, silicon nitride, or silicon carbonitride.
Clause 10. The display device of clause 8 or clause 9, wherein the second dam comprises:
   a second lower dam comprising a same material as the insulating layer and having a third trench surrounding the display area;
   a fourth upper dam on the second lower dam and spaced from the third trench in a plan view;
   a fifth upper dam on the fourth upper dam and spaced from the third trench in a plan view; and
   a sixth upper dam on the fifth upper dam, extending into the third trench, and covering an inner surface of the third trench.
Clause 11. The display device of clause 10, wherein the second lower dam comprises an organic material, and
   wherein each of the fourth upper dam, the fifth upper dam, and the sixth upper dam comprises at least one of silicon oxide, silicon nitride, or silicon carbonitride.
Clause 12. The display device of clause 10 or clause 11, wherein each of the second trench and the third trench has a closed-loop shape.
Clause 13. The display device of any one of clauses 1 to 12, wherein the base substrate comprises a silicon wafer.
Clause 14. The display device of any one of clauses 1 to 13, further comprising:
   a connection pattern in the contact holes of the insulating layer, and
   wherein the connection pattern electrically connects the first pixel electrode and the first pixel circuit part, and electrically connects the second pixel electrode and the second pixel circuit part.
Clause 15. A method of manufacturing a display device, the method comprising:
   forming a transistor layer including a first pixel circuit part corresponding to a first pixel area and a second pixel circuit part corresponding to a second pixel area on a base substrate including a display area including the first pixel area and the second pixel area and a peripheral area around the display area;
   forming an insulating layer on the transistor layer;
   forming a first pixel electrode in the first pixel area and a second pixel electrode in the second pixel area on the insulating layer;
   forming a first preliminary defining layer on the insulating layer to cover the first pixel electrode and the second pixel electrode and exposing a portion of the insulating layer;
   forming a second preliminary defining layer exposing a portion of the insulating layer on the first preliminary defining layer;
   forming a first trench located between the first pixel area and the second pixel area by removing a portion of the insulating layer exposed from the first preliminary defining layer and the second preliminary defining layer;
   forming a third preliminary defining layer on the insulating layer and the second preliminary defining layer to extend into the first trench and cover an inner surface of the first trench; and
   forming a pixel defining layer exposing a portion of each of the first pixel electrode and the second pixel electrode, extending into the first trench, and covering the inner surface of the first trench by removing a portion of the first preliminary defining layer, a portion of the second preliminary defining layer, and a portion of the third preliminary defining layer.
Clause 16. The method of clause 15, wherein each of the first preliminary defining layer, the second preliminary defining layer, and the third preliminary defining layer comprises at least one of silicon oxide, silicon nitride, or silicon carbonitride.
Clause 17. The method of clause 15 or clause 16, wherein, in a cross-sectional view, a width of the first trench is smaller than a separation distance between the first pixel electrode and the second pixel electrode, and
   wherein a thickness of the third preliminary defining layer is smaller than the width of the first trench.
Clause 18. The method of any one of clauses 15 to 17, wherein the pixel defining layer comprises:
   a first defining layer on the insulating layer formed by removing the portion of the first preliminary defining layer;
   a second defining layer on the first defining layer formed by removing the portion of the second preliminary defining layer; and
   a third defining layer on the second defining layer formed by removing the portion of the third preliminary defining layer,
   wherein the first defining layer and the second defining layer are spaced from the first trench, and
   wherein the third defining layer extends into the first trench and covers the inner surface of the first trench.
Clause 19. The method of any one of clauses 15 to 18, further comprising:
   forming a common layer disconnected by the first trench on the insulating layer and the pixel defining layer; and
   forming a common electrode on the common layer that is not disconnected by the first trench,
   wherein the forming the common layer and the forming the common electrode is performed after the forming the pixel defining layer.
Clause 20. The method of any one of clauses 15 to 19, wherein in the forming the insulating layer, a first lower dam in the peripheral area and surrounding the display area and a second lower dam in the peripheral area and surrounding the first lower dam are formed, and
   in the forming the first trench, a second trench surrounding the display area is formed on the first lower dam, and a third trench surrounding the second trench is formed on the second lower dam.
Clause 21. The method of clause 20, wherein the second trench and the third trench are formed to have a closed-loop shape.
Clause 22. The method of clause 20 or clause 21, wherein in the forming the pixel defining layer,
   a first upper dam is formed on the first lower dam to be spaced from the second trench by removing the portion of the first preliminary defining layer,
   a second upper dam is formed on the first upper dam to be spaced from the second trench by removing the portion of the second preliminary defining layer, and
   a third upper dam is formed on the second upper dam to extend into the second trench and cover an inner surface of the second trench by removing the portion of the third preliminary defining layer.
Clause 23. The method of clause 22, wherein the first lower dam is formed of an organic material, and
   each of the first upper dam, the second upper dam, and the third upper dam comprises at least one of silicon oxide, silicon nitride, or silicon carbonitride.
Clause 24. The method of any one of clauses 20 to 23, wherein in the forming the pixel defining layer,
   a fourth upper dam is formed on the second lower dam to be spaced from the third trench by removing the portion of the first preliminary defining layer,
   a fifth upper dam is formed on the fourth upper dam to be spaced from the third trench by removing the portion of the second preliminary defining layer, and
   a sixth upper dam is formed on the fifth upper dam to extend into the third trench and cover an inner surface of the third trench by removing the portion of the third preliminary defining layer.
Clause 25. The method of clause 24, wherein the second lower dam comprises an organic material, and
   each of the fourth upper dam, the fifth upper dam, and the sixth upper dam comprises at least one of silicon oxide, silicon nitride, or silicon carbonitride.

## Claims

1. A display device comprising:
a base substrate including a display area including a first pixel area and a second pixel area, and a peripheral area around the display area;
a transistor layer on the base substrate and comprising a first pixel circuit part corresponding to the first pixel area and a second pixel circuit part corresponding to the second pixel area;
an insulating layer disposed on the transistor layer and having contact holes exposing the first pixel circuit part and the second pixel circuit part and a first trench located between the first pixel area and the second pixel area;
a first pixel electrode located at the first pixel area on the insulating layer and electrically connected to the first pixel circuit part;
a second pixel electrode located at the second pixel area on the insulating layer and electrically connected to the second pixel circuit part; and
a pixel defining layer on the insulating layer, the first pixel electrode, and the second pixel electrode, exposing a portion of each of the first pixel electrode and the second pixel electrode, extending into the first trench, and covering an inner surface of the first trench.

2. The display device of claim 1, wherein the pixel defining layer comprises:
a first defining layer on the insulating layer and spaced from the first trench in a plan view;
a second defining layer on the first defining layer and spaced from the first trench in a plan view; and
a third defining layer on the second defining layer, extending into the first trench, and covering the inner surface of the first trench.

3. The display device of claim 2, wherein:
(i) the insulating layer comprises an organic material, and
wherein each of the first defining layer, the second defining layer, and the third defining layer comprises at least one of silicon oxide, silicon nitride, or silicon carbonitride; and/or
(ii) in a cross-sectional view, a width of the first trench is smaller than a separation distance between the first pixel electrode and the second pixel electrode, and
wherein a thickness of the third defining layer is smaller than the width of the first trench; and/or
(iii) wherein a side surface of the pixel defining layer has a step-shaped step.

4. The display device of any one of claims 1 to 3, further comprising:
a common layer on the insulating layer and the pixel defining layer and disconnected by the first trench; and
a common electrode on the common layer and not disconnected by the first trench, optionally wherein the common layer comprises:
a first hole transport layer;
a first light emitting layer on the first hole transport layer;
a first electron transport layer on the first light emitting layer;
a first charge generation layer on the first electron transport layer;
a second hole transport layer on the first charge generation layer;
a second light emitting layer on the second hole transport layer;
a second electron transport layer on the second light emitting layer;
a second charge generation layer on the second electron transport layer;
a third hole transport layer on the second charge generation layer;
a third light emitting layer on the third hole transport layer; and
a third electron transport layer on the third light emitting layer.

5. The display device of any one of claims 1 to 4, further comprising:
a first dam in the peripheral area and surrounding the display area; and
a second dam in the peripheral area and surrounding the first dam, and
wherein the first dam comprises:
a first lower dam comprising a same material as the insulating layer and having a second trench surrounding the display area;
a first upper dam on the first lower dam and spaced from the second trench in a plan view;
a second upper dam on the first upper dam and spaced from the second trench in a plan view; and
a third upper dam on the second upper dam, extending into the second trench, and covering an inner surface of the second trench.

6. The display device of claim 5, wherein the first lower dam comprises an organic material, and
wherein each of the first upper dam, the second upper dam, and the third upper dam comprises at least one of silicon oxide, silicon nitride, or silicon carbonitride.

7. The display device of claim 5 or claim 6, wherein the second dam comprises:
a second lower dam comprising a same material as the insulating layer and having a third trench surrounding the display area;
a fourth upper dam on the second lower dam and spaced from the third trench in a plan view;
a fifth upper dam on the fourth upper dam and spaced from the third trench in a plan view; and
a sixth upper dam on the fifth upper dam, extending into the third trench, and covering an inner surface of the third trench, optionally wherein:
(i) the second lower dam comprises an organic material, and
wherein each of the fourth upper dam, the fifth upper dam, and the sixth upper dam comprises at least one of silicon oxide, silicon nitride, or silicon carbonitride; and/or
(ii) each of the second trench and the third trench has a closed-loop shape.

8. The display device of any one of claims 1 to 7, wherein:
(i) the base substrate comprises a silicon wafer; and/or
(ii) the display device further comprises:
a connection pattern in the contact holes of the insulating layer, and
wherein the connection pattern electrically connects the first pixel electrode and the first pixel circuit part, and electrically connects the second pixel electrode and the second pixel circuit part.

9. A method of manufacturing a display device, the method comprising:
forming a transistor layer including a first pixel circuit part corresponding to a first pixel area and a second pixel circuit part corresponding to a second pixel area on a base substrate including a display area including the first pixel area and the second pixel area and a peripheral area around the display area;
forming an insulating layer on the transistor layer;
forming a first pixel electrode in the first pixel area and a second pixel electrode in the second pixel area on the insulating layer;
forming a first preliminary defining layer on the insulating layer to cover the first pixel electrode and the second pixel electrode and exposing a portion of the insulating layer;
forming a second preliminary defining layer exposing a portion of the insulating layer on the first preliminary defining layer;
forming a first trench located between the first pixel area and the second pixel area by removing a portion of the insulating layer exposed from the first preliminary defining layer and the second preliminary defining layer;
forming a third preliminary defining layer on the insulating layer and the second preliminary defining layer to extend into the first trench and cover an inner surface of the first trench; and
forming a pixel defining layer exposing a portion of each of the first pixel electrode and the second pixel electrode, extending into the first trench, and covering the inner surface of the first trench by removing a portion of the first preliminary defining layer, a portion of the second preliminary defining layer, and a portion of the third preliminary defining layer.

10. The method of claim 9, wherein each of the first preliminary defining layer, the second preliminary defining layer, and the third preliminary defining layer comprises at least one of silicon oxide, silicon nitride, or silicon carbonitride.

11. The method of claim 9 or claim 10, wherein, in a cross-sectional view, a width of the first trench is smaller than a separation distance between the first pixel electrode and the second pixel electrode, and
wherein a thickness of the third preliminary defining layer is smaller than the width of the first trench.

12. The method of any one of claims 9 to 11, wherein the pixel defining layer comprises:
a first defining layer on the insulating layer formed by removing the portion of the first preliminary defining layer;
a second defining layer on the first defining layer formed by removing the portion of the second preliminary defining layer; and
a third defining layer on the second defining layer formed by removing the portion of the third preliminary defining layer,
wherein the first defining layer and the second defining layer are spaced from the first trench, and
wherein the third defining layer extends into the first trench and covers the inner surface of the first trench.

13. The method of any one of claims 9 to 12, further comprising:
forming a common layer disconnected by the first trench on the insulating layer and the pixel defining layer; and
forming a common electrode on the common layer that is not disconnected by the first trench,
wherein the forming the common layer and the forming the common electrode is performed after the forming the pixel defining layer.

14. The method of any one of claims 9 to 13, wherein in the forming the insulating layer, a first lower dam in the peripheral area and surrounding the display area and a second lower dam in the peripheral area and surrounding the first lower dam are formed, and
in the forming the first trench, a second trench surrounding the display area is formed on the first lower dam, and a third trench surrounding the second trench is formed on the second lower dam.

15. The method of claim 14, wherein:
(i) the second trench and the third trench are formed to have a closed-loop shape; and/or
(ii) in the forming the pixel defining layer,
a first upper dam is formed on the first lower dam to be spaced from the second trench by removing the portion of the first preliminary defining layer,
a second upper dam is formed on the first upper dam to be spaced from the second trench by removing the portion of the second preliminary defining layer, and
a third upper dam is formed on the second upper dam to extend into the second trench and cover an inner surface of the second trench by removing the portion of the third preliminary defining layer, optionally wherein the first lower dam is formed of an organic material, and
each of the first upper dam, the second upper dam, and the third upper dam comprises at least one of silicon oxide, silicon nitride, or silicon carbonitride; and/or
(iii) in the forming the pixel defining layer,
a fourth upper dam is formed on the second lower dam to be spaced from the third trench by removing the portion of the first preliminary defining layer,
a fifth upper dam is formed on the fourth upper dam to be spaced from the third trench by removing the portion of the second preliminary defining layer, and
a sixth upper dam is formed on the fifth upper dam to extend into the third trench and cover an inner surface of the third trench by removing the portion of the third preliminary defining layer, optionally wherein the second lower dam comprises an organic material, and
each of the fourth upper dam, the fifth upper dam, and the sixth upper dam comprises at least one of silicon oxide, silicon nitride, or silicon carbonitride.
